# EUROPEAN PATENT SPECIFICATION

(11) **EP 3 710 398 B1**
(45) Date of publication and mention of the grant of the patent: **25.09.2024**
(21) Application number: 19894087.6
(22) Date of filing: 30.08.2019
(51) Int. Cl.: H10N 50/10, H10N 50/85, G11C 11/16, B82Y 25/00

(54) **SPIN-TRANSFER TORQUE MRAM WITH ASSIST LAYERS AND METHOD OF OPERATING THE SAME**
SPIN-TRANSFER TORQUE-MRAM MIT HILFSSCHICHTEN UND VERFAHREN ZU DESSEN BETRIEB
MRAM À COUPLE DE TRANSFERT DE SPIN POURVUE DE COUCHES D'ASSISTANCE ET MÉTHODE DE FONCTIONNEMENT DE CELUI-CI

(30) Priority: 06.12.2018 US 201816212257; 06.12.2018 US 201816212342; 06.12.2018 US 201816212420
(43) Date of publication of application: 23.09.2020
(73) Proprietor: SanDisk Technologies LLC, Addison, Texas 75001 (US)
(72) Inventor: LE, Quang, San Jose, California 95119 (US); LI, Zhanjie, San Jose, California 95119 (US); BAI, Zhigang, San Jose, California 95119 (US); VANDERHEIJDEN, Paul, San Jose, California 95119 (US); HO, Michael, San Jose, California 95119 (US)
(74) Representative: Dehns
(86) International application number: PCT/US2019/049189
(87) International publication number: WO 2020/117341

(56) References cited:
- US-A1- 2002 105 823
- US-A1- 2009 237 987
- US-A1- 2011 007 560
- US-A1- 2011 007 560
- US-A1- 2011 241 139
- US-A1- 2016 372 656
- US-A1- 2016 372 656
- US-A1- 2016 379 698
- US-A1- 2018 248 110
- SBIAA R ET AL: "Spin transfer switching enhancement in perpendicular anisotropy magnetic tunnel junctions with a canted in-plane spin polarizer", JOURNAL OF APPLIED PHYSICS, vol. 105, 013910, 6 January 2009 (2009-01-06), XP012119458, ISSN: 0021-8979, DOI: 10.1063/1.3055373

## Description

### RELATED APPLICATION

The present application claims priority to U.S. Non-Provisional Application Serial Nos. 16/212,257, 16/212,342 and 16/212,420, all filed December 6, 2018.

### FIELD

The present disclosure relates generally to the field of magnetic memory devices and specifically to a spin-transfer torque (STT) magnetoresistive random access memory (MRAM) device with assist layers and a method of operating the same.

### BACKGROUND

Spin-transfer torque (STT) refers to an effect in which the orientation of a magnetic layer in a magnetic tunnel junction or spin valve is modified by a spin-polarized current. Generally, electric current is unpolarized with electrons having random spin orientations. A spin polarized current is one in which electrons have a net non-zero spin due to a preferential spin orientation distribution. A spin-polarized current can be generated by passing electrical current through a magnetic polarizer layer. When the spin-polarized current flows through a free layer of a magnetic tunnel junction or a spin valve, the electrons in the spin-polarized current can transfer at least some of their angular momentum to the free layer, thereby producing torque to magnetize the free layer. When a sufficient amount of spin-polarized current passes through the free layer, spin-transfer torque can be employed to flip the orientation of the spin (e.g., change the magnetization) in the free layer. A resistance differential of a magnetic tunnel junction between different magnetization states of the free layer can be employed to store data within the magnetoresistive random access memory (MRAM) cell depending if the magnetization of the free layer is parallel or antiparallel to the magnetization of a reference layer. US2016/0372656 A1 describes a precessional spin current (PSC) structure for MRAM. A similar MRAM device with PSC structure in conjunction with a perpendicular MTJ is known from US2018/0248110 A1. The PSC structure comprises first and second PSC ferromagnetic layers separated by a nonmagnetic PSC insertion layer. US2011/0241139 A1 describes magnetic random access memory. US2011/0007560 A1 describes a spin polarized magnetic device. US2009/0237987 A1 describes a crossbar diode-switched magnetoresistive random access memory system. In the Journal of Applied Physics 105, 01390 (2009), Rachid Sbiaa et al. describe "Spin transfer switching enhancement in perpendicular anisotropy magnetic tunnel junctions with a canted in-plane spin polarizer". All said documents disclose MRAM devices according to the preamble of independent claim 1.

### SUMMARY

According to an aspect of the present invention, an MRAM device includes a magnetic tunnel junction containing a reference layer having a fixed magnetization direction, a free layer, and a nonmagnetic tunnel barrier layer located between the reference layer and the free layer, a negative-magnetic-anisotropy assist layer having negative magnetic anisotropy that provides an in-plane magnetization within a plane that is perpendicular to the fixed magnetization direction, and a first nonmagnetic spacer layer located between the free layer and the negative-magnetic-anisotropy assist layer. The MRAM device includes a pinned magnetization layer having a positive uniaxial magnetic anisotropy which provides a magnetization direction that is parallel or antiparallel to the fixed magnetization direction of the reference layer, and a second nonmagnetic spacer layer located between the negative-magnetic-anisotropy assist layer and the pinned magnetization layer.

According to another aspect of the present invention, a method of operating said MRAM device is provided.

### BRIEF DESCRIPTION OF THE DRAWINGS

FIG. 1 is a schematic diagram of a memory device including resistive memory cells of the present disclosure in an array configuration.
FIG. 2 illustrates a first configuration of an exemplary STT MRAM cell according to a first example of the present disclosure, such as known from the prior art.
FIG. 3 illustrates a second configuration of the exemplary STT MRAM cell according to the first example, which is not in accordance with the present invention.
FIG. 4 illustrates a configuration of an exemplary STT MRAM cell according to an embodiment of the present invention.
FIG. 5 illustrates an alternative configuration of an exemplary STT MRAM cell according to an embodiment of the present invention.
FIG. 6A illustrates an exemplary precession pattern during transition of the spin of a free layer from an up state to a down state.
FIG. 6B illustrates an exemplary precession pattern during transition of the spin of a free layer from a down state to an up state.
FIG. 7 illustrates a first configuration of an exemplary STT MRAM cell according to a second example, which is not in accordance with the present invention.
FIG. 8 illustrates a second configuration of an exemplary STT MRAM cell according to the second example.
FIG. 9 illustrates a third configuration of an exemplary STT MRAM cell according to the second example.
FIG. 10 illustrates a fourth configuration of an exemplary STT MRAM cell according to the second example.
FIG. 11 illustrates a comparative STT MRAM cell.
FIG. 12 is a graph illustrating the transition probability as a function of a current density through the comparative STT MRAM cell.
FIG. 13 is a graph illustrating the transition probability as a function of a current density through an exemplary STT MRAM cell of the second example.
FIG. 14 illustrates a first configuration of an exemplary STT MRAM cell according to a third example, which is not in accordance with the present invention.
FIG. 15 illustrates antiferromagnetic coupling between the magnetization of a spin torque layer and a spin polarization layer within the exemplary spin-transfer torque MRAM cell in a first coupling mode.
FIG. 16 illustrates antiferromagnetic coupling between the magnetization of a spin torque layer and a spin polarization layer within the exemplary spin-transfer torque MRAM cell in a second coupling mode.
FIG. 17 illustrates antiferromagnetic coupling between the magnetization of a spin torque layer and a spin polarization layer within the exemplary spin-transfer torque MRAM cell in a third coupling mode.
FIG. 18 illustrates antiferromagnetic coupling between the magnetization of a spin torque layer and a spin polarization layer within the exemplary spin-transfer torque MRAM cell in a fourth coupling mode.
FIG. 19 illustrates a second configuration of an exemplary an MRAM cell according to the third example.
FIG. 20 illustrates a third configuration of an exemplary MRAM cell according to the third example.
FIG. 21 illustrates a fourth configuration of an exemplary MRAM cell according to the third example.

### DETAILED DESCRIPTION

As discussed above, the present invention is directed to a spin-transfer torque (STT) MRAM device with assist layers and a method of operating the same, the various aspects of which are described below.

The drawings are not drawn to scale. Multiple instances of an element may be duplicated where a single instance of the element is illustrated, unless absence of duplication of elements is expressly described or clearly indicated otherwise. Same reference numerals refer to the same element or to a similar element. Elements having the same reference numerals are presumed to have the same material composition unless expressly stated otherwise. Ordinals such as "first," "second," and "third" are employed merely to identify similar elements, and different ordinals may be employed across the specification and the claims of the instant disclosure. As used herein, a first element located "on" a second element can be located on the exterior side of a surface of the second element or on the interior side of the second element. As used herein, a first element is located "directly on" a second element if there exist a physical contact between a surface of the first element and a surface of the second element. As used herein, an "in-process" structure or a "transient" structure refers to a structure that is subsequently modified.

As used herein, a "layer" refers to a material portion including a region having a thickness. A layer may extend over the entirety of an underlying or overlying structure, or may have an extent less than the extent of an underlying or overlying structure. Further, a layer may be a region of a homogeneous or inhomogeneous continuous structure that has a thickness less than the thickness of the continuous structure. For example, a layer may be located between any pair of horizontal planes between, or at, a top surface and a bottom surface of the continuous structure. A layer may extend horizontally, vertically, and/or along a tapered surface. A substrate may be a layer, may include one or more layers therein, and/or may have one or more layer thereupon, thereabove, and/or therebelow.

As used herein, a "layer stack" refers to a stack of layers. As used herein, a "line" or a "line structure" refers to a layer that has a predominant direction of extension, i.e., having a direction along which the layer extends the most.

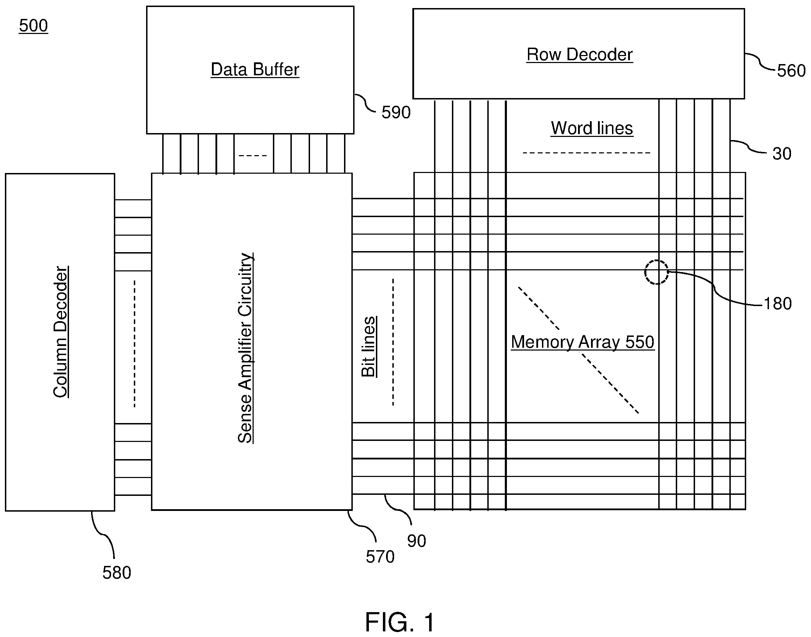

Referring to FIG. 1, a schematic diagram is shown for a magnetic memory device including memory cells 180 of an embodiment of the present invention in an array configuration. The magnetic memory device can be configured as an MRAM device 500 containing MRAM cells 180. As used herein, an "MRAM device" refers to a memory device containing cells that allow random access, e.g., access to any selected memory cell upon a command for reading the contents of the selected memory cell.

The MRAM device 500 includes a memory array region 550 containing an array of the respective MRAM cells 180 located at the intersection of the respective word lines (which may comprise electrically conductive lines 30 as illustrated or as second electrically conductive lines 90 in an alternate configuration) and bit lines (which may comprise second electrically conductive lines 90 as illustrated or as first electrically conductive lines 30 in an alternate configuration). The MRAM device 500 may also contain a row decoder 560 connected to the word lines, a sense circuitry 570 (e.g., a sense amplifier and other bit line control circuitry) connected to the bit lines, a column decoder 580 connected to the bit lines, and a data buffer 590 connected to the sense circuitry. Multiple instances of the MRAM cells 180 are provided in an array configuration that forms the MRAM device 500. As such, each of the MRAM cells 180 can be a two-terminal device including a respective first electrode and a respective second electrode. It should be noted that the location and interconnection of elements are schematic and the elements may be arranged in a different configuration. Further, an MRAM cell 180 may be manufactured as a discrete device, i.e., a single isolated device.

Each MRAM cell 180 includes a magnetic tunnel junction or a spin valve having at least two different resistive states depending on the alignment of magnetizations of different magnetic material layers. The magnetic tunnel junction or the spin valve is provided between a first electrode and a second electrode within each MRAM cell 180. Configurations of the MRAM cells 180 are described in detail in subsequent sections.

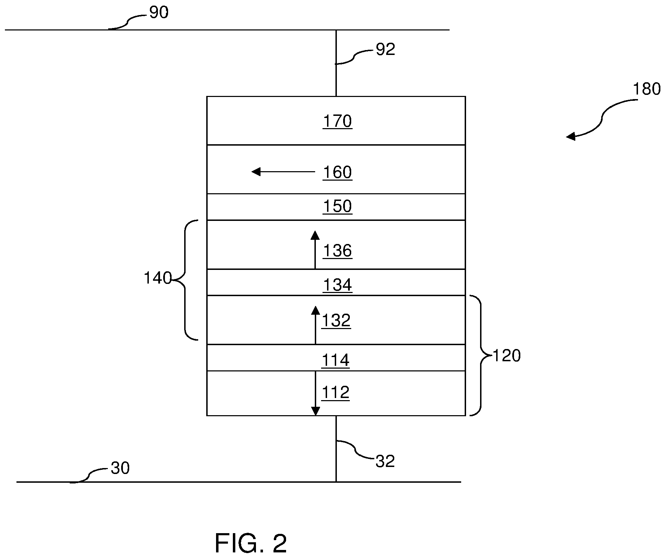

Referring to FIG. 2, a first configuration of an exemplary STT MRAM cell 180 of a first example, such as known from the prior art, is schematically illustrated. The STT MRAM cell 180 includes a magnetic tunnel junction (MTJ) 140. The magnetic tunnel junction 140 includes a reference layer 132 having a fixed vertical magnetization, a nonmagnetic tunnel barrier layer 134 located between the reference layer 132 and the free layer 136. In one configuration, the reference layer 132 is located below the nonmagnetic tunnel barrier layer 134, while the free layer 136 is located above the nonmagnetic tunnel barrier layer 134. However, in other configurations, the reference layer 132 is located above the nonmagnetic tunnel barrier layer 134, while the free layer 136 is located below the nonmagnetic tunnel barrier layer 134, or the reference layer 132 and the free layer 136 may be located on opposite lateral sides nonmagnetic tunnel barrier layer 134. The reference layer 132 and the free layer 136 have respective positive uniaxial magnetic anisotropy.

Generally, a magnetic thin film has magnetic energy per unit volume that depends on the orientation of the magnetization of the magnetic material of the magnetic thin film. The magnetic energy per unit volume can be approximated by a polynomial of the angle θ (or of sin²θ) between the direction of the magnetization and the vertical axis that is perpendicular to the plane of the magnetic thin film (such as a top surface or a bottom surface of the magnetic thin film) and the azimuthal angle φ between the direction of magnetization and a fixed vertical plane that is perpendicular to the plane of the magnetic thin film. The first and second order terms for the magnetic energy per unit volume as a function of sin²θ includes K₁sin²θ + K₂sin⁴θ. When K₁ is negative and K₂ is less than -K₁/2, the function K₁sin²θ + K₂sin⁴θ has a minimum when θ is at π/2. If the magnetic anisotropy energy as a function of θ has a minimum only when θ is at π/2, the magnetization of the magnetic film prefers to stay entirely within the plane of the film, and the film is said to have "negative magnetic anisotropy." If the magnetic anisotropy energy as a function of θ has a minimum only when θ is at 0 or π, the magnetization of the magnetic film is perpendicular to the plane of the film, and the film is said to have "positive magnetic anisotropy." A thin crystalline magnetic film having positive magnetic anisotropy has a tendency for magnetization to stay perpendicular to the plane of the thin crystalline magnetic film, i.e., perpendicular to the two directions along which the thin crystalline magnetic film laterally extends. A thin crystalline magnetic film having negative magnetic anisotropy has a magnetization within the plane of the thin crystalline magnetic film, although within the film plane magnetization doesn't have a preferred orientation.

The configuration in which the reference layer 132 and the free layer 136 have respective positive uniaxial magnetic anisotropy provides bistable magnetization states for the free layer 136. The bistable magnetization states include a parallel state in which the free layer 136 has a magnetization (e.g., magnetization direction) that is parallel to the fixed vertical magnetization (e.g., magnetization direction) of the reference layer 132, and an antiparallel state in which the free layer 136 has a magnetization (e.g., magnetization direction) that is antiparallel to the fixed vertical magnetization (e.g., magnetization direction) of the reference layer 132.

The reference layer 132 can include either a Co/Ni or Co/Pt multilayer structure. The reference layer 132 can additionally include a thin non-magnetic layer comprised of tantalum having a thickness of 0.2 nm ~ 0.5 nm and a thin CoFeB layer (having a thickness in a range from 0.5 nm to 3 nm). The nonmagnetic tunnel barrier layer 134 can include any tunneling barrier material such as an electrically insulating material, for example magnesium oxide. The thickness of the nonmagnetic tunnel barrier layer 134 can be 0.7 nm to 1.3 nm, such as about 1 nm. The free layer 136 can includes alloys of one or more of Fe, Co, and/or Ni, such as CoFeB, at a composition that provides positive uniaxial magnetic anisotropy.

The reference layer 132 may be provided as a component within a synthetic antiferromagnetic structure (SAF structure) 120. The SAF structure 120 can include the reference layer 132, a fixed ferromagnetic layer 112 having a magnetization that is antiparallel to the fixed vertical magnetization, and an antiferromagnetic coupling layer 114 located between the reference layer 132 and the fixed ferromagnetic layer 112 facing the first side of the reference layer 132 opposite to the second side of the reference layer 132 which faces the nonmagnetic tunnel barrier layer 134. The antiferromagnetic coupling layer 114 has a thickness that induces an antiferromagnetic coupling between the reference layer 132 and the fixed ferromagnetic layer 112. In other words, the antiferromagnetic coupling layer 114 can lock in the antiferromagnetic alignment between the magnetization of the reference layer 132 and the magnetization of the fixed ferromagnetic layer 112 to lock in place the magnetizations of the reference layer 132 and the magnetization of the fixed ferromagnetic layer 112. The antiferromagnetic coupling layer can include ruthenium and can have a thickness in a range from 0.3 nm to 1 nm.

A first nonmagnetic spacer layer 150 is provided over the second side of the free layer 136 opposite to the first side of the free layer 136 which faces the nonmagnetic tunnel barrier layer 134. The first nonmagnetic spacer layer 150 includes a nonmagnetic material such as tantalum, ruthenium, tantalum nitride, copper, copper nitride, or magnesium oxide. The first nonmagnetic spacer layer 150 can include an electrically conductive metallic material. Alternatively, the first nonmagnetic spacer layer 150 can include a tunneling dielectric material such as magnesium oxide. The thickness of the first nonmagnetic spacer layer 150 can be in a range from 0.2 nm to 2 nm, although lesser and greater thicknesses can also be employed.

A negative-magnetic-anisotropy assist layer 160 can be provided over the first nonmagnetic spacer layer 150 and over the second side of the free layer 136. The negative-magnetic-anisotropy assist layer 160 can have negative magnetic anisotropy with a sufficiently negative K₁ value to provide an in-plane magnetization for the negative-magnetic-anisotropy assist layer 160. The in-plane magnetization is a magnetization located within a horizontal plane in FIG. 2 that is perpendicular to the fixed vertical magnetization of the reference layer 132.

The hard magnetization axis is parallel to the direction normal to a major surface of the negative-magnetic-anisotropy assist layer 160 (i.e., the axis is perpendicular to the plane of the layer 160 and parallel to fixed vertical magnetization of the reference layer 132), whereas the easy magnetization plane is parallel to the plane of the negative-magnetic-anisotropy assist layer 160 (i.e., the easy magnetization plane is perpendicular to the fixed vertical magnetization of the reference layer 132 in FIG. 2). Within the plane (i.e., the easy magnetization plane) of the negative-magnetic-anisotropy assist layer 160, there is no easy axis direction. The negative-magnetic-anisotropy assist layer 160 is spin-coupled with the free layer 136 through the first nonmagnetic spacer layer 150.

The azimuthally-dependent component of the magnetic anisotropy of the negative-magnetic-anisotropy assist layer 160 may be zero or insignificant compared to the thermal energy at room temperature, i.e., k_{B}T in which k_{B} is the Boltzmann constant and T is 297.15 Kelvin (which is the room temperature). For example, the maximum variation of the magnetic anisotropy per unit volume around a vertical axis that is parallel to the fixed vertical magnetization of the reference layer 132 can be less than 1/2 times the thermal energy at room temperature. In such cases, the magnetization of the negative-magnetic-anisotropy assist layer 160 is free to precess within the horizontal plane that is parallel to the interface between the first nonmagnetic spacer layer 150 and the negative-magnetic-anisotropy assist layer 160 upon application of electrical current through the negative-magnetic-anisotropy assist layer 160. The magnetic energy of the negative-magnetic-anisotropy assist layer 160 may be invariant under rotation of the magnetization of the negative-magnetic-anisotropy assist layer 160 within the horizontal plane.

In one configuration, the negative-magnetic-anisotropy assist layer 160 comprises a homogeneous negative magnetic anisotropy material. As used herein, a "homogeneous" material refers to a material having a uniform material composition throughout. In one embodiment, the negative-magnetic-anisotropy assist layer 160 comprises, and/or consists essentially of, a cobalt-iridium alloy. The material composition of the cobalt-iridium alloy can be selected to provide negative magnetic anisotropy. The cobalt-iridium alloy can include cobalt atoms at an atomic concentration in a range from 60 % to 98 %, such as from 70 % to 90 %, for example 80 %, and iridium atoms at the atomic concentration in a range from 40 % to 2 %, such as from 30 % to 10 %, for example 20 %. In one configuration, the cobalt-iridium alloy contains only cobalt, iridium and unavoidable impurities. In another configuration, up to 5 atomic percent of elements other than cobalt and iridium may be added to the alloy. In an illustrative example, a cobalt-iridium alloy having a composition of Co_{0.8}Ir_{0.2} has a K₁ value of about -0.6 × 10⁶ J/m³. In another configuration, the negative-magnetic-anisotropy assist layer 160 comprises, and/or consists essentially of, a cobalt-iron alloy. The material composition of the cobalt-iron alloy can be selected to provide negative magnetic anisotropy. The cobalt-iron alloy can include cobalt atoms at an atomic concentration in a range from 80 % to 99.8 %, such as from 90 % to 99.5 %, such as 99 %, and iron atoms at the atomic concentration in a range from 20 % to 0.2 %, such as from 10 % to 0.5 %, for example 1 %. In an illustrative example, a cobalt-iron alloy having a composition of Co_{0.9}Fe_{0.1} has a K₁ value of about -0.99 × 10⁶ J/m³. The thickness of the negative-magnetic-anisotropy assist layer 160 can be in a range from 1 nm to 10 nm, such as from 1.5 nm to 6 nm, although lesser and greater thicknesses can also be employed.

A nonmagnetic capping layer 170 can be located over the negative-magnetic-anisotropy assist layer 160. The nonmagnetic capping layer 170 can include a non-magnetic, electrically conductive material, such as W, Ti, Ta, WN, TiN, TaN, Ru, and Cu. The thickness of the nonmagnetic capping layer 170 can be in a range from 1 nm to 20 nm, although lesser and greater thicknesses can also be employed.

The layer stack including the material layers from the SAF structure 120 to the nonmagnetic capping layer 170 can be deposited upward or downward, i.e., from the SAF structure 120 toward the nonmagnetic capping layer 170 or from the nonmagnetic capping layer 170 toward the SAF structure 120. The layer stack can be formed as a stack of continuous layers, and can be subsequently patterned into discrete patterned layer stacks for each MRAM cell 180.

MRAM cell 180 can include a first terminal 92 that is electrically connected to or comprises a portion of a bit line 90 (shown in FIG. 1) and second terminal 32 that is electrically connected to or comprises a portion of a word line 30 (shown in FIG. 1). The location of the first and second terminals may be switched such that the first terminal is electrically connected to the SAF structure 120 and the second terminal is electrically connected to the capping layer 170.

Optionally, each MRAM cell 180 can include a dedicated steering device, such an access transistor or diode configured to activate a respective discrete patterned layer stack (120, 140, 150, 160, 170) upon application of a suitable voltage to the steering device. The steering device may be electrically connected between the patterned layer stack and one of the respective word lines 30 or bit lines 90 of the respective MRAM cell 180.

The polarity of the voltage applied to the first terminal 92 can be changed depending on the polarity of the magnetization state to be programmed in the free layer 136. For example, a voltage of a first polarity can be applied to the first terminal 92 (with respect to the second terminal 32) during a transition from an antiparallel state to a parallel state, and a voltage of a second polarity (which is the opposite of the first polarity) can be applied to the first terminal 92 during a transition from a parallel state to an antiparallel state. Further, variations in the circuitry for activating the discrete patterned layer stack (120, 140, 150, 160, 170) are also contemplated herein.

The magnetization direction of the free layer 136 can be flipped (i.e., from upward to downward or vice versa) by flowing electrical current through the discrete patterned layer stack (120, 140, 150, 160, 170). The magnetization of the free layer 136 can precess around the vertical direction (i.e., the direction of the flow of the electrical current) during the programming process until the direction of the magnetization flips by 180 degrees, at which point the flow of the electrical current stops. In one configuration, the magnetization of the negative-magnetic-anisotropy assist layer 160 can rotate freely around a vertical axis that is parallel to the fixed magnetization direction of the reference layer 132 while electrical current flows through the discrete patterned layer stack (120, 140, 150, 160, 170). This configuration allows the negative-magnetic-anisotropy assist layer 160 to provide an initial non-vertical torque to the magnetization of the free layer 136 during an initial phase of precession of the magnetization of the free layer 136 around the vertical axis that is parallel to the fixed vertical magnetization of the reference layer 132 upon initiation of flow of electrical current through the MRAM cell 180.

The MRAM cell 180 can be configured to provide coupling between the in-plane magnetization of the negative-magnetic-anisotropy assist layer 160 and the magnetization of the free layer 136 during precession of the magnetization of the free layer 136 around a vertical axis that is parallel to the fixed vertical magnetization of the reference layer 132, and to provide synchronized precession of the in-plane magnetization of the negative-magnetic-anisotropy assist layer 160 and the magnetization of the free layer 136 while electrical current flows through the MRAM cell 180.

Due to the negative magnetic anisotropy of the negative-magnetic-anisotropy assist layer 160, the in-plane magnetization of the negative-magnetic-anisotropy assist layer 160 can provide an initial torque to the free layer to facilitate the initiation of switching of the free layer 136. Once the free layer 136 precession starts, the free layer 136 can provide a spin torque to the negative-magnetic-anisotropy assist layer 160 to cause the negative-magnetic-anisotropy assist layer 160 magnetization to precess as well. This negative-magnetic-anisotropy assist layer 160 precession can in turn further assist the switching of the free layer 136. The negative-magnetic-anisotropy assist layer 160 which has an in-plane easy magnetization plane but which lacks a fixed easy axis direction, is more efficient than a prior art assist layer where the assist layer's magnetization direction (e.g., easy axis) is fixed.

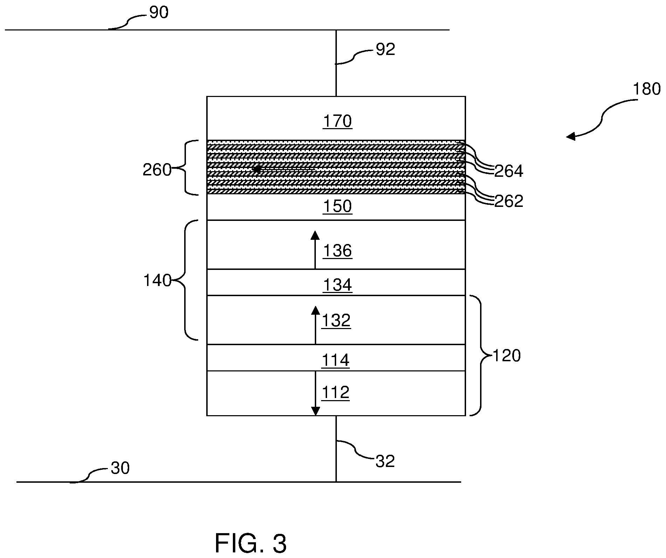

Referring to FIG. 3, a second configuration of the exemplary spin-transfer torque MRAM cell 180 can be derived from the first configuration of the exemplary spin-transfer torque MRAM cell 180 of FIG. 2 by replacing the negative-magnetic-anisotropy assist layer 160 having a homogeneous material composition with a negative-magnetic-anisotropy assist layer 260 including a multilayer stack (262, 264). The multilayer stack (262, 264) can include multiple repetitions of a first magnetic material layer 262 and a second magnetic material layer 264. The first magnetic material layer 262 can include, and/or can consist essentially of, a first magnetic material. The second magnetic material layer 264 can include, and/or can consist essentially of, a second magnetic material.

The composition and the thickness of each first magnetic material layer 262 and the composition and the thickness of each second magnetic material layer 264 can be selected such that the multilayer stack (262, 264) provides an in-plane magnetization, i.e., a magnetization that is perpendicular to the fixed magnetization direction of the reference layer 132 (i.e., an easy magnetization plane that is perpendicular to the fixed magnetization direction of the reference layer 132 without an easy magnetization axis). The negative-magnetic-anisotropy assist layer 260 can have negative magnetic anisotropy with a sufficiently negative K₁ value to provide the in-plane magnetization for the negative-magnetic-anisotropy assist layer 260.

The azimuthally-dependent component of the magnetic anisotropy of the negative-magnetic-anisotropy assist layer 260 may be zero or insignificant compared to the thermal energy at room temperature. For example, the maximum variation of the magnetic anisotropy per unit volume around a vertical axis that is parallel to the fixed vertical magnetization of the reference layer 132 can be less than 1/2 times the thermal energy at room temperature. In such cases, the magnetization of the negative-magnetic-anisotropy assist layer 260 is free to precess within the plane that is parallel to the interface between the first nonmagnetic spacer layer 150 and the negative-magnetic-anisotropy assist layer 260 upon application of electrical current through the negative-magnetic-anisotropy assist layer 260. The magnetic energy of the negative-magnetic-anisotropy assist layer 260 may be invariant under rotation of the magnetization of the negative-magnetic-anisotropy assist layer 260 within the horizontal plane.

The first magnetic material layers 262 may comprise cobalt, and the second magnetic material layers 264 may comprise iron. In one configuration, the first magnetic material layers 262 consist essentially of cobalt, and the second magnetic material layers 264 consist essentially of iron. The thickness of each first magnetic material layer 262 can be in a range from 0.3 nm to 1 nm, and the thickness of each second magnetic material layer 264 can be in a range from 0.3 nm to 1 nm. The total number of repetitions (i.e., the total number of pairs of a first magnetic material layer 262 and a second magnetic material layer 264) within the negative-magnetic-anisotropy assist layer 260 can be in a range from 2 to 20, such as from 4 to 10. The multilayer stack (262, 264) may comprise a periodic repetition of a unit layer stack that includes a first magnetic material layer 262 and a second magnetic material layer 264. In an illustrative example, a cobalt-iron multilayer stack including repetitions of a unit layer stack consisting of a cobalt layer and an iron layer having the same thickness can have a K₁ value of about -1.1 × 10⁶ J/m³.

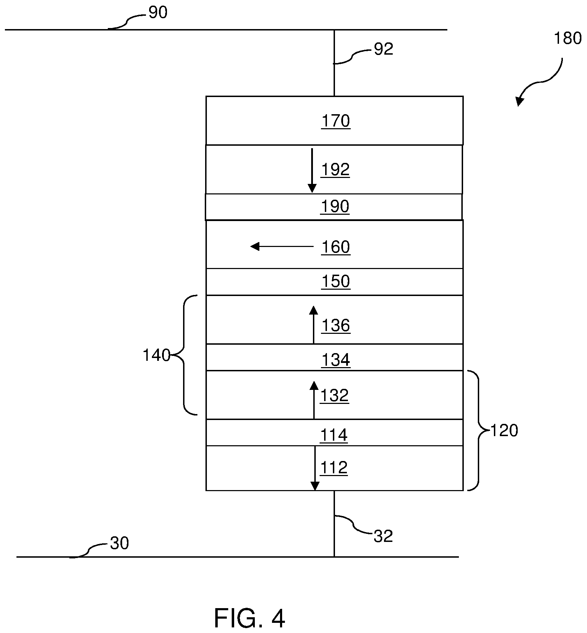

Referring to FIG. 4, an embodiment of the exemplary spin-transfer torque MRAM cell 180 according to the present invention can be derived from the first configuration of the exemplary spin-transfer torque MRAM cell 180 of FIG. 2 by inserting a second nonmagnetic spacer layer 190 and a pinned magnetization layer 192 between the negative-magnetic-anisotropy assist layer 160 and the nonmagnetic capping layer 170.

The second nonmagnetic spacer layer 190 can be located on the negative-magnetic-anisotropy assist layer 160 on the opposite side from the first nonmagnetic spacer layer 150. The second nonmagnetic spacer layer 190 includes a nonmagnetic material such as tantalum, ruthenium, tantalum nitride, copper, copper nitride, or magnesium oxide. In one embodiment, the second nonmagnetic spacer layer 190 can include an electrically conductive material. Alternatively, the second nonmagnetic spacer layer 190 can include a dielectric material such as magnesium oxide. The thickness of the second nonmagnetic spacer layer 190 can be in a range from 0.2 nm to 2 nm, although lesser and greater thicknesses can also be employed. The second nonmagnetic spacer layer 190 can include the same material as, or can include a material different from, the material of the first nonmagnetic spacer layer 150.

The pinned magnetization layer 192 is a magnetic layer which has a positive uniaxial magnetic anisotropy. In other words, the value of K₁ is positive and the term K₁sin²θ dominates all other higher order terms and terms depending on sin(nφ) (or cos(nφ)) in the magnetic anisotropy energy per volume for the material of the pinned magnetization layer 192. The positive uniaxial magnetic anisotropy of the pinned magnetization layer 192 provides a magnetization that is parallel or antiparallel to the fixed vertical magnetization of the reference layer 132. In one embodiment, the value of K₁ for the pinned magnetization layer 192 can be greater than the value of K₁ for the free layer 136 such that the magnetization of the pinned magnetization layer 192 stays pinned along the vertical direction, i.e., perpendicular to the interfaces among the various layers of the discrete patterned layer stack (120, 140, 150, 160, 190, 192, 170), during programming of the MRAM cell 180. The magnetization of the pinned magnetization layer 192 may remain parallel to, or antiparallel to, the magnetization of the reference layer 132.

In one embodiment, the pinned magnetization layer 192 can include either a Co/Ni or Co/Pt multilayer structure. The pinned magnetization layer 192 can additionally include a thin non-magnetic layer comprised of tantalum having a thickness of 0.2 nm ~ 0.5 nm and a thin CoFeB layer (having a thickness in a range from 0.5 nm to 3 nm). The pinned magnetization layer 192 can cause the in-plane magnetization of the negative-magnetic-anisotropy assist layer 160 to oscillate. The oscillation of the in-plane magnetization of the negative-magnetic-anisotropy assist layer 160 can produce a rotating spin torque on the magnetization of the free layer 136 during programming, and thus, can help the switching of the magnetization of the free layer 136 with a lower electrical current through the discrete patterned layer stack (120, 140, 150, 160, 190, 192, 170). In one embodiment, the combination of the magnetization of the pinned magnetization layer 192 and the negative-magnetic-anisotropy assist layer 160 applies a non-horizontal and non-vertical magnetic field (i.e., a field which is neither parallel to nor perpendicular to the direction of the magnetization of the reference layer 132) on the magnetization of the free layer 136 to reduce the magnitude of the required electrical current through the discrete patterned layer stack (120, 140, 150, 160, 190, 192, 170) during switching of the magnetization of the free layer 136.

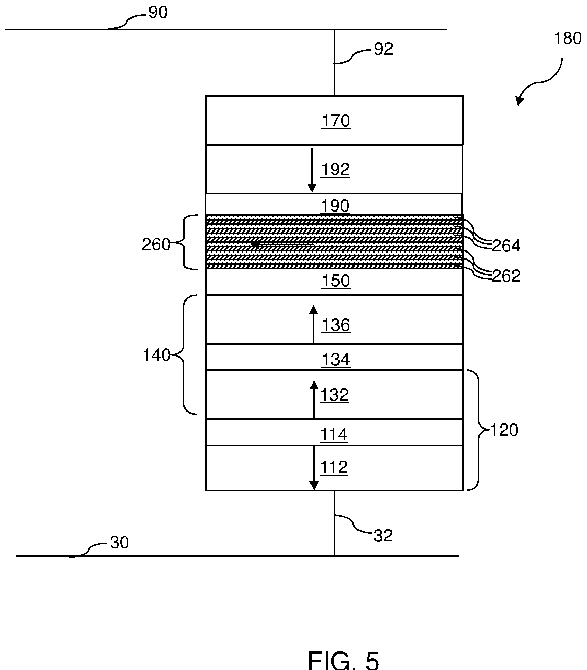

Referring to FIG. 5, another embodiment of the exemplary spin-transfer torque MRAM cell 180 according to the present invention can be derived from the configuration of the exemplary spin-transfer torque MRAM cell 180 of FIG. 4 by replacing the negative-magnetic-anisotropy assist layer 160 having a homogeneous material composition with the negative-magnetic-anisotropy assist layer 260 containing the multilayer stack (262, 264) that includes multiple repetitions of a first magnetic material layer 262 and a second magnetic material layer 264 that was described above with respect to FIG. 3.

Referring to all configurations of the exemplary spin-transfer torque MRAM cell 180 illustrated in FIGS. 1 - 5, the exemplary spin-transfer torque MRAM cell 180 can be programmed and read individually. Reading, i.e., sensing, the magnetization state of the free layer 136 can be performed by applying a read bias voltage across the first terminal 92 and the second terminal 32 of a selected discrete patterned layer stack {120, 140, 150, (160 or 260), 170} or {120, 140, 150, (160 or 260), (190, 192), 170}. The parallel or antiparallel alignment between the magnetization of the free layer 136 and the reference layer 132 determines the electrical resistance of the selected discrete patterned layer stack in each MRAM cell 180, and thus, determines the magnitude of the electrical current that flows between the first terminal 92 and the second terminal 32. The magnitude of the electrical current can be sensed to determine the magnetization state of the free layer 136 and the data encoded by the detected magnetization state.

Programming of the exemplary spin-transfer torque MRAM cell 180 to the opposite magnetization state for the free layer 136 can be performed by flowing electrical current through the selected discrete patterned layer stack {120, 140, 150, (160 or 260), 170} or {120, 140, 150, (160 or 260), (190, 192), 170} and by inducing the flipping, i.e., the switching, of the direction of the magnetization of the free layer 136. Specifically, electrical current can be flowed through a selected discrete patterned layer stack which includes a magnetic tunnel junction 140, a first nonmagnetic spacer layer 150, and a negative-magnetic-anisotropy assist layer (160 or 260). The in-plane magnetization of the negative-magnetic-anisotropy assist layer (160 or 260) provides an initial non-vertical torque to the magnetization of the free layer 136 during an initial phase of precession of the magnetization of the free layer 136 around a vertical axis that is parallel to the fixed vertical magnetization of the reference layer 132 upon initiation of flow of the electrical current through the magnetic tunnel junction 140, the first nonmagnetic spacer layer 150, and the negative-magnetic-anisotropy assist layer (160 or 260).

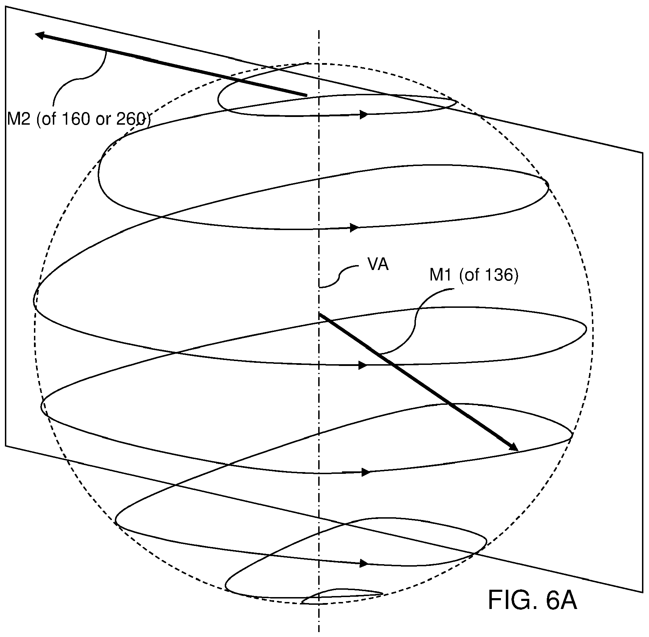

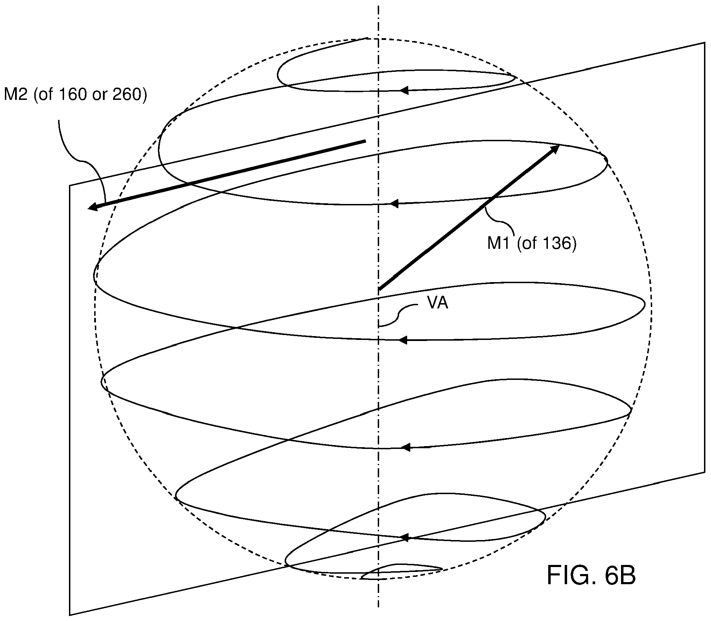

In one embodiment, the in-plane magnetization of the negative-magnetic-anisotropy assist layer (160 or 260) couples with a magnetization of the free layer 136 during precession of the magnetization of the free layer 136 around the vertical axis (VA) that is parallel to the fixed vertical magnetization of the reference layer 132 to provide synchronized precession of the in-plane magnetization M2 of the negative-magnetic-anisotropy assist layer (160 or 260) and the magnetization M1 of the free layer 136 while electrical current flows through the MRAM cell 180 as illustrated in FIGS. 6A and 6B. FIG. 6A illustrates a transition of the magnetization M1 of the free layer 136 from an "up" state to a "down" state, and FIG. 6B illustrates a transition of the magnetization M1 of the free layer 136 from a "down" state to an "up" state. In one embodiment, the in-plane magnetization M2 of the negative-magnetic-anisotropy assist layer (160 or 260) and the magnetization M1 of the free layer 136 may remain within a same rotating vertical plane during the switching of the magnetization of the free layer 136. The coupling between the horizontal (in-plane) component of the magnetization M1 of the free layer 136 and the in-plane magnetization M2 of the negative-magnetic-anisotropy assist layer (160 or 260) may be antiferromagnetic or ferromagnetic. FIGS. 6A and 6B illustrate an example in which the coupling between the horizontal (in-plane) component of the magnetization M1 of the free layer 136 and the in-plane magnetization M2 of the negative-magnetic-anisotropy assist layer (160 or 260) is antiferromagnetic during the switching of the magnetization of the free layer 136.

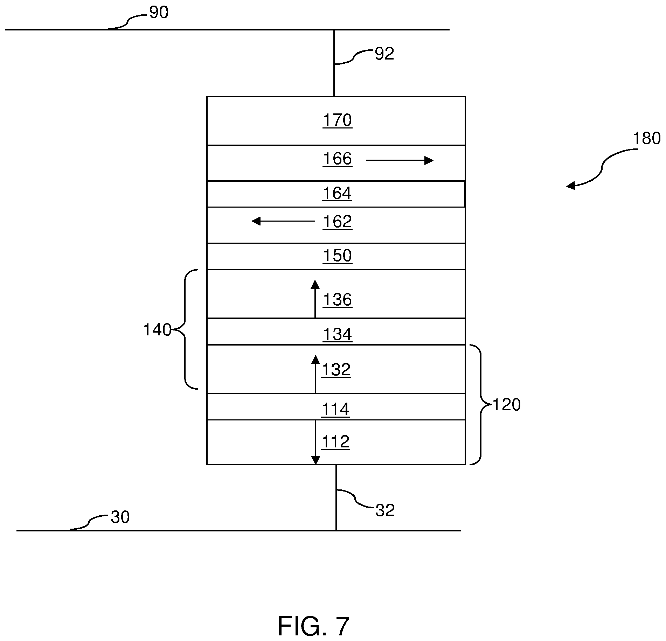

FIG. 7 illustrates a STT MRAM cell 180 according to the second example. Layers 112, 114, 132, 134, 136 and 150 of the STT MRAM cell 180 of the second example may be the same as respective layers 112, 114, 132, 134, 136 and 150 of the STT MRAM cell 180 of the first example illustrated in FIG. 2, and thus are described above with respect to the first embodiment. A first magnetic assist layer 162 can be provided on the first nonmagnetic spacer layer 150. The first magnetic assist layer 162 includes a first magnetic material having a first magnetic anisotropy. In one embodiment, the first magnetic assist layer 162 can have a first negative magnetic anisotropy with a sufficiently negative K₁ value to provide a first in-plane magnetization for the first magnetic assist layer 162. The in-plane magnetization is a magnetization located within a horizontal plane that is perpendicular to the fixed vertical magnetization direction of the reference layer 132.

The azimuthally-dependent component of the first magnetic anisotropy of the first magnetic assist layer 162 may be zero or insignificant compared to the thermal energy at room temperature, i.e., k_{B}T in which k_{B} is the Boltzmann constant and T is 297.15 Kelvin (which is the room temperature). For example, the maximum variation of the magnetic anisotropy energy per unit volume around a vertical axis that is parallel to the fixed vertical magnetization of the reference layer 132 can be less than 1/2 times the thermal energy at room temperature. In such cases, the magnetization of the first magnetic assist layer 162 is free to precess within the horizontal plane that is parallel to the interface between the first nonmagnetic spacer layer 150 and the first magnetic assist layer 162 upon application of electrical current through the first magnetic assist layer 162. In one embodiment, the magnetic energy of the first magnetic assist layer 162 may be invariant under rotation of the magnetization of the first magnetic assist layer 162 within the horizontal plane.

A material having a negative magnetic anisotropy, such as the first magnetic assist layer 162, may have a hard magnetization axis that parallel to the direction normal to a major surface of the layer (i.e., the axis is perpendicular to the plane of the layer and parallel to fixed vertical magnetization direction of the reference layer 132), whereas the easy magnetization plane is parallel to the plane of the layer (i.e., the easy magnetization plane is perpendicular to the fixed vertical magnetization direction of the reference layer 132 in FIG. 7). In one example, there is no easy axis direction within the easy magnetization plane.

The first magnetic assist layer 162 may comprise a homogeneous negative magnetic anisotropy material. As used herein, a "homogeneous" material refers to a material having a uniform material composition throughout. The first magnetic assist layer 162 may comprise, and/or consist essentially of, a cobalt-iridium alloy. The material composition of the cobalt-iridium alloy can be selected to provide negative magnetic anisotropy. The cobalt-iridium alloy can include cobalt atoms at an atomic concentration in a range from 60 % to 98 %, such as from 70 % to 90 %, for example 80 %, and iridium atoms at the atomic concentration in a range from 40 % to 2 %, such as from 30 % to 10 %, for example 20 %. The cobalt-iridium alloy may contain only cobalt, iridium and unavoidable impurities. In another configuration, up to 5 atomic percent of elements other than cobalt and iridium may be added to the alloy. In an illustrative example, a cobalt-iridium alloy having a composition of Co_{0.8}Ir_{0.2} has a K₁ value of about -0.6 × 10⁶ J/m³. The first magnetic assist layer 162 may comprise, and/or consist essentially of, a cobalt-iron alloy having a hexagonal crystal structure. The material composition of the cobalt-iron alloy can be selected to provide negative magnetic anisotropy. The cobalt-iron alloy can include cobalt atoms at an atomic concentration in a range from 80 % to 99.8 %, such as from 90 % to 99.5 %, such as 99 %, and iron atoms at the atomic concentration in a range from 20 % to 0.2 %, such as from 10 % to 0.5 %, for example 1 %. In an illustrative example, a cobalt-iron alloy having a composition of Co_{0.9}Fe_{0.1} has a K₁ value of about -0.99 × 10⁶ J/m³. The thickness of the first magnetic assist layer 162 can be in a range from 1 nm to 10 nm, such as from 1.5 nm to 6 nm, although lesser and greater thicknesses can also be employed.

The first magnetic assist layer 162 may comprise a multilayer stack that includes multiple repetitions of a first magnetic material layer and a second magnetic material layer. The first magnetic material layer can include, and/or can consist essentially of, a first magnetic material. The second magnetic material layer can include, and/or can consist essentially of, a second magnetic material. The composition and the thickness of each first magnetic material layer and the composition and the thickness of each second magnetic material layer can be selected such that the multilayer stack provides an in-plane magnetization, i.e., a magnetization that is perpendicular to the fixed magnetization direction of the reference layer 132. The first magnetic assist layer 162 can have negative magnetic anisotropy with a sufficiently negative K₁ value to provide the first in-plane magnetization for the first magnetic assist layer 162.

The first magnetic material layers may comprise cobalt, and the second magnetic material layers may comprise iron. The first magnetic material layers may consist essentially of cobalt, and the second magnetic material layers may consist essentially of iron. The thickness of each first magnetic material layer can be in a range from 0.3 nm to 1 nm, and the thickness of each second magnetic material layer can be in a range from 0.3 nm to 1 nm. The total number of repetitions (i.e., the total number of pairs of a first magnetic material layer and a second magnetic material layer) within the first magnetic assist layer 162 can be in a range from 2 to 20, such as from 4 to 10. The multilayer stack may comprise a periodic repetition of a unit layer stack that includes a first magnetic material layer and a second magnetic material layer.

An antiferromagnetic coupling spacer layer 164 can be located between the first and second magnetic assist layers, such as on the first magnetic assist layer 162 on the opposite side of the first nonmagnetic spacer layer 150, which is located between the free layer 136 and the first magnetic assist layer 162. The antiferromagnetic coupling spacer layer 164 comprises a metallic material that induces Ruderman-Kittel-Kasuya-Yosida (RKKY) coupling interaction between the first magnetic assist layer 152 and a second magnetic assist layer 166 that may be located on the antiferromagnetic coupling spacer layer 164. In the RKKY coupling interaction, localized inner d- or f-shell electron spins that define the magnetization direction of a ferromagnetic metal layer interact through the conduction electrons in an intervening nonmagnetic material layer to define a direction of preferred magnetization direction in another ferromagnetic metal layer. The thickness of the antiferromagnetic coupling spacer layer 164 can be selected such that a second in-plane magnetization direction of a second magnetic assist layer 166 is antiparallel to the first in-plane magnetization direction of the first magnetic assist layer 162. In other words, the antiferromagnetic coupling spacer layer 164 can have a thickness within a range that provides antiferromagnetic coupling between a first magnetization direction of the first magnetic assist layer 162 and a second magnetization direction of the second magnetic assist layer 166The antiferromagnetic coupling spacer layer 164 may comprise, or consist essentially of, ruthenium, and has a thickness within a range from 0.1 nm to 1.0 nm.

A second magnetic assist layer 166 can be provided on the antiferromagnetic coupling spacer layer 164. The second magnetic assist layer 166 includes a second magnetic material having second magnetic anisotropy, which can be the same as or different from the material of the first magnetic assist layer 162. The second magnetic assist layer 166 can have a second negative magnetic anisotropy with a sufficiently negative K₁ value to provide a second in-plane magnetization direction for the second magnetic assist layer 166. The in-plane magnetization direction is a magnetization direction located within a horizontal plane that is perpendicular to the fixed vertical magnetization direction of the reference layer 132.

The azimuthally-dependent component of the magnetic anisotropy of the second magnetic assist layer 166 may be zero or insignificant compared to the thermal energy at room temperature, i.e., k_{B}T in which k_{B} is the Boltzmann constant and T is 297.15 Kelvin (which is the room temperature). For example, the maximum variation of the magnetic anisotropy per unit volume around a vertical axis that is parallel to the fixed vertical magnetization of the reference layer 132 can be less than 1/2 times the thermal energy at room temperature. In such cases, the magnetization of the second magnetic assist layer 166 is free to precess within the horizontal plane that is parallel to the interface between the antiferromagnetic coupling spacer layer 164 and the second magnetic assist layer 166 upon application of electrical current through the second magnetic assist layer 166. The magnetic energy of the second magnetic assist layer 166 may be invariant under rotation of the magnetization of the second magnetic assist layer 166 within the horizontal plane.

The second magnetic assist layer 166 may comprise a homogeneous negative magnetic anisotropy material. The second magnetic assist layer 166 may comprise, and/or consist essentially of, a cobalt-iridium alloy or a cobalt-iron alloy described with respect to the first magnetic assist layer 162. The material composition of the cobalt-iridium alloy can be selected to provide negative magnetic anisotropy. The cobalt-iridium alloy can include cobalt atoms at an atomic concentration in a range from 20 % to 80 % and iridium atoms at the atomic concentration of the balance. The thickness of the second magnetic assist layer 166 can be in a range from 1 nm to 10 nm, such as from 1.5 nm to 6 nm, although lesser and greater thicknesses can also be employed.

The second magnetic assist layer 166 may comprise a multilayer stack that includes multiple repetitions of a first magnetic material layer and a second magnetic material layer. The first magnetic material layer can include, and/or can consist essentially of, a first magnetic material. The second magnetic material layer can include, and/or can consist essentially of, a second magnetic material. The composition and the thickness of each first magnetic material layer and the composition and the thickness of each second magnetic material layer can be selected such that the multilayer stack provides an in-plane magnetization, i.e., a magnetization that is perpendicular to the fixed magnetization direction of the reference layer 132. The second magnetic assist layer 166 can have negative magnetic anisotropy with a sufficiently negative K₁ value to provide the second in-plane magnetization for the second magnetic assist layer 166.

The first magnetic material layers may comprise cobalt, and the second magnetic material layers may comprise iron. The first magnetic material layers may consist essentially of cobalt, and the second magnetic material layers may consist essentially of iron. The thickness of each first magnetic material layer can be in a range from 0.3 nm to 1 nm, and the thickness of each second magnetic material layer can be in a range from 0.3 nm to 1 nm. The total number of repetitions (i.e., the total number of pairs of a first magnetic material layer and a second magnetic material layer) within the second magnetic assist layer 166 can be in a range from 2 to 20, such as from 4 to 10. The multilayer stack may comprise a periodic repetition of a unit layer stack that includes a first magnetic material layer and a second magnetic material layer.

Generally, each of the first magnetic assist layer 162 and the second magnetic assist layer 166 can be independently selected from a homogeneous negative magnetic anisotropy material, and a multilayer stack including multiple repetitions of a first magnetic material layer and a second magnetic material layer. Each of the first magnetic assist layer 162 and the second magnetic assist layer 166 can be independently selected from a cobalt-iridium alloy, a cobalt-iron alloy having a hexagonal crystal structure and low iron content, or a multilayer stack including multiple repetitions of a unit stack of a cobalt layer and an iron layer. At least one of the first magnetic assist layer 162 and the second magnetic assist layer 166 may comprise a multilayer stack including a periodic repetition of a unit layer stack, and the unit layer stack may include the first magnetic material layer and the second magnetic material.

A nonmagnetic capping layer 170 can be located over the second magnetic assist layer 166. The nonmagnetic capping layer 170 can include a non-magnetic, electrically conductive material, such as W, Ti, Ta, WN, TiN, TaN, Ru, and Cu. The thickness of the nonmagnetic capping layer 170 can be in a range from 1 nm to 20 nm, although lesser and greater thicknesses can also be employed.

The layer stack including the material layers from the SAF structure 120 to the nonmagnetic capping layer 170 can be deposited upward or downward, i.e., from the SAF structure 120 toward the nonmagnetic capping layer 170 or from the nonmagnetic capping layer 170 toward the SAF structure 120. The layer stack can be formed as a stack of continuous layers, and can be subsequently patterned into discrete patterned layer stacks for each MRAM cell 180.

MRAM cell 180 can include a first terminal 92 that is electrically connected to or comprises a portion of a bit line 90 (shown in FIG. 1) and second terminal 32 that is electrically connected to or comprises a portion of a word line 30 (shown in FIG. 1). The location of the first and second terminals may be switched such that the first terminal is electrically connected to the SAF structure 120 and the second terminal is electrically connected to the capping layer 170.

Optionally, each MRAM cell 180 can include a dedicated steering device, such an access transistor or diode configured to activate a respective discrete patterned layer stack (120, 140, 150, 162, 164, 166, 170) upon application of a suitable voltage to the steering device. The steering device may be electrically connected between the patterned layer stack and one of the respective word lines 30 or bit lines 90 of the respective MRAM cell 180.

The polarity of the voltage applied to the first terminal 92 can be changed depending on the polarity of the magnetization state to be programmed in the free layer 136. For example, a voltage of a first polarity can be applied to the first terminal 92 (with respect to the second terminal 32) during a transition from an antiparallel state to a parallel state, and a voltage of a second polarity (which is the opposite of the first polarity) can be applied to the first terminal 92 during a transition from a parallel state to an antiparallel state. Further, variations in the circuitry for activating the discrete patterned layer stack (120, 140, 150, 162, 164, 166, 170) are also contemplated herein.

The magnetization direction of the free layer 136 can be flipped (i.e., from upward to downward or vice versa) by flowing electrical current through the discrete patterned layer stack (120, 140, 150, 162, 164, 166, 170). The magnetization direction of the free layer 136 can precess around the vertical direction (i.e., the direction of the flow of the electrical current) during the programming process until the direction of the magnetization flips by 180 degrees, at which point the flow of the electrical current stops.

The first magnetization direction of the first magnetic assist layer 162 and the second magnetization direction of the second magnetic assist layer 166 are free to precess around a vertical axis that is parallel to the fixed vertical magnetization direction of the reference layer 132 while maintaining an antiferromagnetic alignment therebetween upon application of electrical current through the first magnetic assist layer 162, the antiferromagnetic coupling spacer layer 164, and the second magnetic assist layer 166, e.g., during programming. The fixed vertical magnetization direction of the reference layer 132 maintains a same orientation upon application of electrical current through the reference layer 132.

During operation of the magnetic memory device, electrical current can be flowed through the magnetic tunnel junction 140, the first nonmagnetic spacer layer 150, the first magnetic assist layer 162, the antiferromagnetic coupling spacer layer 164, and the second magnetic assist layer 166.

The first magnetic assist layer 162, the antiferromagnetic coupling spacer layer 164, and the second magnetic assist layer 166 may help keep the electron spin of the free layer more in plane to counteract the spin torque which tilts the electron spin out of the plane. Due to the anti-ferromagnetic coupling, the anti-ferromagnetic coupled assist film comprising the combination of the first magnetic assist layer 162, the antiferromagnetic coupling spacer layer 164, and the second magnetic assist layer 166 further favors single domains within each layer, thus maintaining a more coherent magnetization during the process of assisting the free layer 136 switching, which is more desired. One additional benefit of this example is that the flux closure within the tri-layer assist film may minimize the stray field from the anti-ferromagnetic coupled assist film on the free layer 136, which will help improve the thermal stability and data retention of the MRAM cell 180.

The combination of the first magnetic assist layer 162, the antiferromagnetic coupling spacer layer 164, and the second magnetic assist layer 166 may be configured to provide an initial non-vertical torque to a magnetization of the free layer 136 during an initial phase of precession of the magnetization of the free layer 136 around a vertical axis that is parallel to the fixed vertical magnetization direction of the reference layer 132 upon initiation of flow of electrical current through the MRAM cell 180. The MRAM cell 180 is configured to provide magnetic coupling between the magnetization direction of the free layer 136 and the first magnetization direction of the first magnetic assist layer 162 during precession of the magnetization direction of the free layer 136 around a vertical axis that is parallel to the fixed vertical magnetization direction of the reference layer 132, and to provide synchronized precession of the first magnetization direction of the first magnetic assist layer 162 and the magnetization direction of the free layer 136 while electrical current flows through the MRAM cell 180.

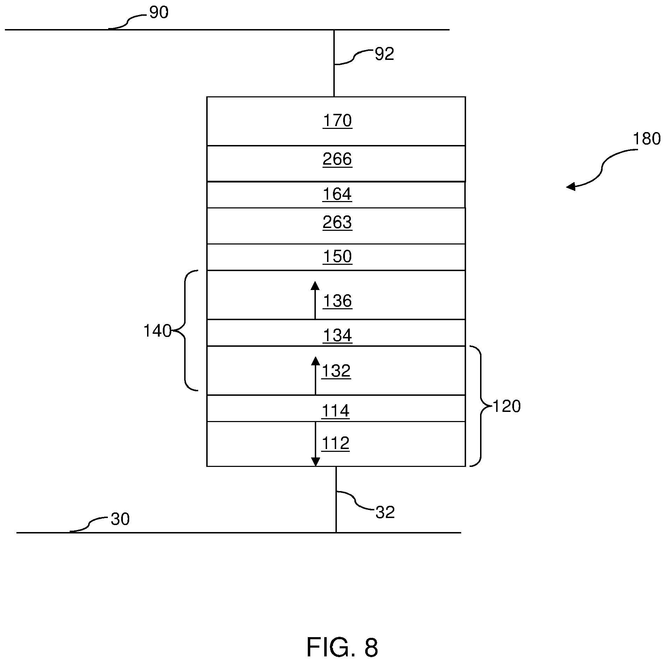

Referring to FIG. 8, a second configuration of the exemplary spin-transfer torque MRAM cell 180 can be derived from the first configuration of the exemplary spin-transfer torque magnetic memory device illustrated in FIG. 7 by replacing the first magnetic assist layer 162 having the first in-plane magnetization with a first magnetic assist layer 263 including a first ferromagnetic material having no uniaxial magnetic anisotropy, and by replacing the second magnetic assist layer 166 having the second in-plane magnetization with a second magnetic assist layer 266 including a second ferromagnetic material having no uniaxial magnetic anisotropy. The first and second magnetic assist layers (263, 266) can have a non-uniaxial magnetic anisotropy. As used herein, a "non-uniaxial magnetic anisotropy" refers to a magnetic anisotropy in which the minimum of the magnetic anisotropy energy per volume does not occur at the direction of θ = 0, θ = π, or θ = π/2 for all values of φ. In other words, the orientation of the magnetization in a magnetic film having a non-uniaxial magnetic anisotropy is not a vertical direction that is perpendicular to the plane of a magnetic film or the set of all in-plane directions.

The thickness of the antiferromagnetic coupling spacer layer 164 is selected to provide an antiferromagnetic coupling between the first magnetization of the first magnetic assist layer 263 and the second magnetization with a second magnetic assist layer 266. Thus, the first magnetization of the first magnetic assist layer 263 and the second magnetization of the second magnetic assist layer 266 can be antiferromagnetically coupled. Further, the variations in the magnetic anisotropy energy per volume as a function of spatial orientations of the first and second magnetizations (which remain antiparallel to each other) can be on par with, or less than, the thermal energy at room temperature, i.e., k_{B}T in which T is 293.15 Kelvin.

Each of the first magnetic assist layer 263 and the second magnetic assist layer 266 comprises a respective soft magnetic material having no uniaxial magnetic anisotropy, which may be the same or different. Each of the first magnetic assist layer 263 and the second magnetic assist layer 266 may comprise, and/or consist essentially of, a respective material selected from a CoFe alloy having more than 40 atomic percent iron, such as 45 to 70 atomic percent iron and balance cobalt or an NiFe alloy.

The magnetization direction of the free layer 136 can be flipped (i.e., from upward to downward or vice versa) by flowing electrical current through the discrete patterned layer stack (120, 140, 150, 263, 164, 266, 170). The magnetization direction of the free layer 136 can precess around the vertical direction (i.e., the direction of the flow of the electrical current) during the programming process until the direction of the magnetization direction flips by 180 degrees, at which point the flow of the electrical current stops.

The magnetization direction of the free layer 136 can be programmed by flowing electrical current through the discrete patterned layer stack (120, 140, 150, 263, 164, 266, 170), e.g., from a parallel state that is parallel to the fixed vertical magnetization direction of the reference layer 132 to an antiparallel state that is antiparallel to the fixed magnetization direction of the reference layer 132 or vice versa. The first magnetization direction of the first magnetic assist layer 263 and the second magnetization direction of the second magnetic assist layer 266 are free to precess around a vertical axis that is parallel to the fixed vertical magnetization direction of the reference layer 132 at an angle between 0 degree and 180 degrees with respect to the vertical axis while maintaining an antiferromagnetic alignment therebetween upon application of electrical current through the first magnetic assist layer 263, the antiferromagnetic coupling spacer layer 164, and the second magnetic assist layer 266, e.g., during programming. The tilt angles of the first magnetization direction of the first magnetic assist layer 263 and the second magnetization direction of the second magnetic assist layer 266 during programming is synchronized with the tilt angle of the magnetization direction of the free layer 136 as the tilt angle changes from 0 degrees to 180 degrees or from 180 degrees to 0 degrees with respect to the vertical axis during programming of the MRAM cell 180. The fixed vertical magnetization direction of the reference layer 132 maintains a same orientation upon application of electrical current through the reference layer 132.

During operation of the magnetic memory device, electrical current can be flowed through the magnetic tunnel junction 140, the first nonmagnetic spacer layer 150, the first magnetic assist layer 263, the antiferromagnetic coupling spacer layer 164, and the second magnetic assist layer 266. The combination of the first magnetic assist layer 263, the antiferromagnetic coupling spacer layer 164, and the second magnetic assist layer 266 is configured to provide an initial non-vertical torque to a magnetization direction of the free layer 136 during an initial phase of precession of the magnetization direction of the free layer 136 around a vertical axis that is parallel to the fixed vertical magnetization direction of the reference layer 132 upon initiation of flow of electrical current through the MRAM cell 180. The MRAM cell 180 is configured to provide magnetic coupling between the magnetization direction of the free layer 136 and the first magnetization direction of the first magnetic assist layer 263 during precession of the magnetization direction of the free layer 136 around a vertical axis that is parallel to the fixed vertical magnetization direction of the reference layer 132, and to provide synchronized precession of the first magnetization direction of the first magnetic assist layer 263 and the magnetization direction of the free layer 136 while electrical current flows through the MRAM cell 180.

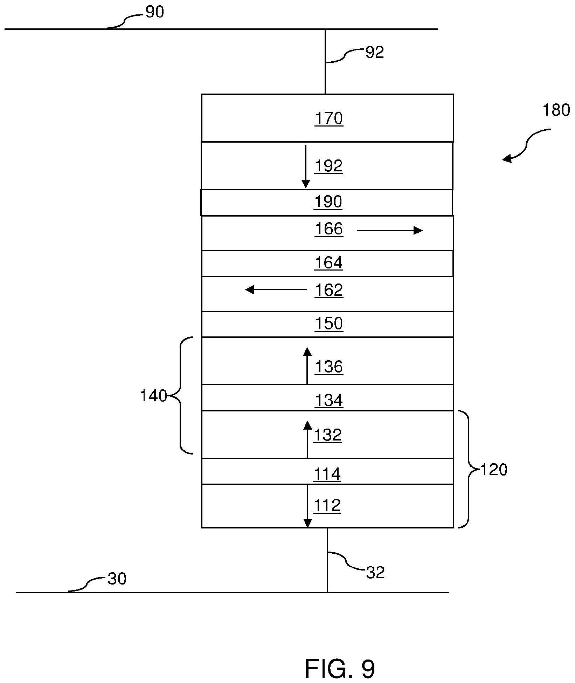

Referring to FIG. 9, a third configuration of the exemplary spin-transfer torque MRAM cell 180 can be derived from the first configuration of the exemplary spin-transfer torque MRAM cell 180 of FIG. 7 by inserting a second nonmagnetic spacer layer 190 and a pinned magnetization layer 192 between the second magnetic assist layer 166 and the nonmagnetic capping layer 170.

The second nonmagnetic spacer layer 190 can be located on the second magnetic assist layer 166 on the opposite side of the antiferromagnetic coupling spacer layer 164. The second nonmagnetic spacer layer 190 includes a nonmagnetic material such as tantalum, ruthenium, tantalum nitride, copper, copper nitride, or magnesium oxide. The second nonmagnetic spacer layer 190 can include an electrically conductive material. Alternatively, the second nonmagnetic spacer layer 190 can include a tunneling dielectric material such as magnesium oxide. The thickness of the second nonmagnetic spacer layer 190 can be in a range from 0.2 nm to 2 nm, although lesser and greater thicknesses can also be employed. The second nonmagnetic spacer layer 190 can include the same material as, or can include a material different from, the material of the first nonmagnetic spacer layer 150.

The pinned magnetization layer 192 is a magnetic layer which has a positive uniaxial magnetic anisotropy. In other words, the value of K₁ is positive and the term K₁sin²θ dominates all other higher order terms and terms depending on sin(nφ) (or cos(nφ)) in the magnetic anisotropy energy per volume for the material of the pinned magnetization layer 192. The positive uniaxial magnetic anisotropy of the pinned magnetization layer 192 provides a magnetization that is parallel or antiparallel to the fixed vertical magnetization of the reference layer 132. The value of K₁ for the pinned magnetization layer 192 can be greater than the value of K₁ for the free layer 136 such that the magnetization of the pinned magnetization layer 192 stays pinned along the vertical direction, i.e., perpendicular to the interfaces among the various layers of the discrete patterned layer stack (120, 140, 150, 162, 164, 166, 190, 192, 170), during programming of the MRAM cell 180. The magnetization of the pinned magnetization layer 192 may remain parallel to, or antiparallel to, the magnetization of the reference layer 132.

The pinned magnetization layer 192 can include either a Co/Ni or Co/Pt multilayer structure. The pinned magnetization layer 192 can additionally include a thin non-magnetic layer comprised of tantalum having a thickness of 0.2 nm ~ 0.5 nm and a thin CoFeB layer (having a thickness in a range from 0.5 nm to 3 nm). The pinned magnetization layer 192 can cause the in-plane magnetization of the second magnetic assist layer 166 to oscillate. The out-of-plane oscillation of the magnetization of the second magnetic assist layer 166 can produce a rotating spin torque on the magnetization of the free layer 136 during programming, and thus, can help the switching of the magnetization of the free layer 136 with lesser electrical current through the discrete patterned layer stack (120, 140, 150, 162, 164, 166, 190, 192, 170). The combination of the magnetization of the pinned magnetization layer 192, the first magnetic assist layer 162, and second magnetic assist layer 166 may apply a non-horizontal non-vertical magnetic field (i.e., a field which is neither parallel to not perpendicular to the fixed magnetization direction of the reference layer 132) on the magnetization of the free layer 136 to reduce the magnitude of the required electrical current through the discrete patterned layer stack (120, 140, 150, 162, 164, 166, 190, 192, 170) during switching of the magnetization of the free layer 136.

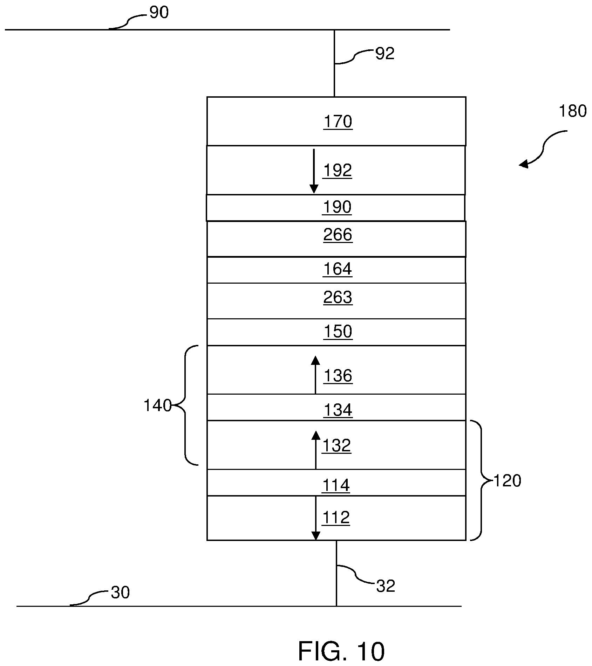

Referring to FIG. 10, a fourth configuration of the exemplary spin-transfer torque MRAM cell 180 can be derived from the third configuration of the exemplary spin-transfer torque magnetic memory device illustrated in FIG. 9 by replacing the first magnetic assist layer 162 having the first in-plane magnetization with a first magnetic assist layer 263 including a first ferromagnetic material having no uniaxial magnetic anisotropy, and by replacing the second magnetic assist layer 166 having the second in-plane magnetization with a second magnetic assist layer 266 including a second ferromagnetic material having no uniaxial magnetic anisotropy.

The thickness of the antiferromagnetic coupling spacer layer 164 is selected to provide an antiferromagnetic coupling between the first magnetization of the first magnetic assist layer 263 and the second magnetization with a second magnetic assist layer 266. Thus, the first magnetization of the first magnetic assist layer 263 and the second magnetization of the second magnetic assist layer 266 can be antiferromagnetically coupled. Further, the variations in the magnetic anisotropy energy per volume as a function of spatial orientations of the first and second magnetizations (which remain antiparallel to each other) can be on par with, or less than, the thermal energy at room temperature, i.e., k_{B}T in which T is 293.15 Kelvin.

Referring to all configurations of the exemplary spin-transfer torque MRAM cell 180 illustrated in FIGS. 1 and 7-10, the exemplary spin-transfer torque MRAM cell 180 can be programmed and read individually. Reading, i.e., sensing, the magnetization state of the free layer 136 can be performed by applying a read bias voltage across the first terminal 92 and the second terminal 32 of a selected discrete patterned layer stack {120, 140, 150, (162 or 263), 164, (166 or 266), 170} or {120, 140, 150, (162 or 263), 164, (166 or 266), (190, 192), 170}. The parallel or antiparallel alignment between the magnetization of the free layer 136 and the reference layer 132 determines the electrical resistance of the selected discrete patterned layer stack in each MRAM cell 180, and thus, determines the magnitude of the electrical current that flows between the first terminal 92 and the second terminal 32. The magnitude of the electrical current can be sensed to determine the magnetization state of the free layer 136 and the data encoded by the detected magnetization state.

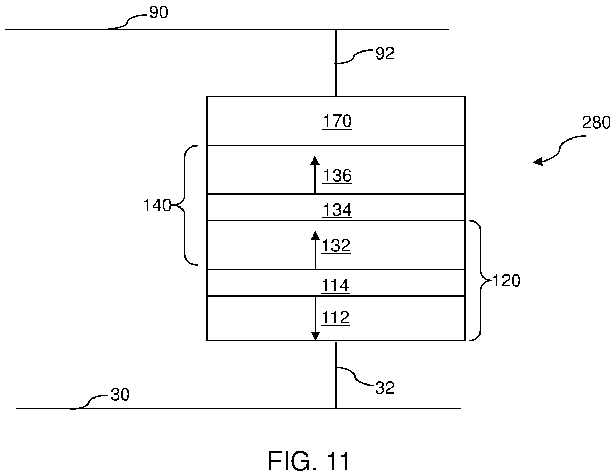

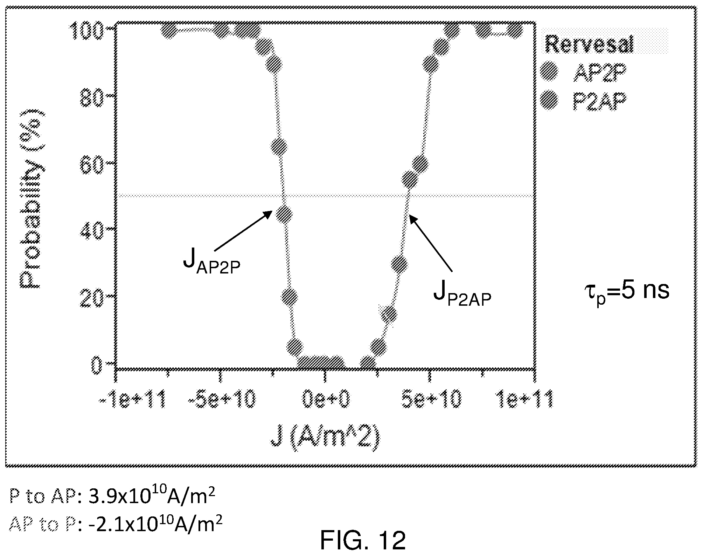

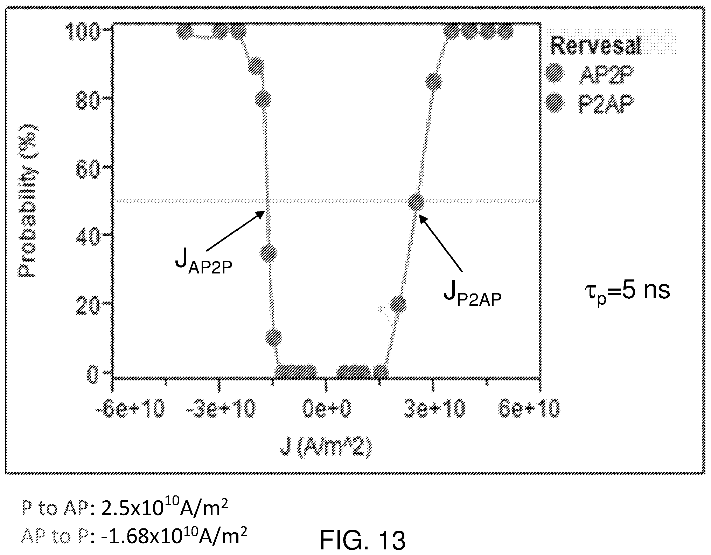

FIG. 11 illustrates a comparative spin-transfer torque MRAM cell 280 that can be derived from the exemplary spin-transfer torque MRAM cell 180 by omitting all magnetic assist layer (162, 166, 263, 266), the antiferromagnetic coupling spacer layer 164, the second nonmagnetic spacer layer 190, and the pinned magnetization layer 192. Thus, the assist features during precessing of the magnetization of the free layer 136 are absent in the comparative spin-transfer torque MRAM cell 280. The effects of the first and second magnetic assist layer (162, 166) and the antiferromagnetic coupling spacer layer 164 in the first configuration of the exemplary spin-transfer torque MRAM cell 180 are illustrated in FIGS. 12 and 13.

FIG. 12 is a graph illustrating the transition probability as a function of a current density through the comparative spin-transfer torque magnetic memory device of FIG. 11. FIG. 13 is a graph illustrating the transition probability as a function of a current density through the first configuration of the exemplary spin-transfer torque magnetic memory device illustrated in FIG. 7. The areas of the devices of FIGS. 12 and 13 are substantially the same.

FIG. 12 shows that the current density of about 3.9 × 10¹⁰ A/m² is necessary to induce a transition within 5 nanoseconds from a parallel state to an antiparallel state for the magnetization of the free layer 136 and that the current density of about -2.1 × 10¹⁰ A/m² is necessary to induce a transition within 5 nanoseconds from an antiparallel state to a parallel state for the magnetization of the free layer 136 for the comparative spin-transfer torque MRAM cell 280 of FIG. 11. FIG. 13 shows that the current density of about 2.5 × 10¹⁰ A/m² is necessary to induce a transition within 5 nanoseconds from a parallel state to an antiparallel state for the magnetization of the free layer 136 and that the current density of about -1.68 × 10¹⁰ A/m² is necessary to induce a transition within 5 nanoseconds from an antiparallel state to a parallel state for the magnetization of the free layer 136 for the exemplary spin-transfer torque MRAM cell 180 of FIG. 7. Thus, FIGS. 12 and 13 illustrate that the presence of the first and second magnetic assist layer (162, 166) and the antiferromagnetic coupling spacer layer 164 in the first configuration of the exemplary spin-transfer torque MRAM cell 180 reduces the required the current density (i.e., the magnitude of the switching current) for making the parallel to antiparallel transition and the current density for making the antiparallel to parallel transition for the first configuration of the exemplary spin-transfer torque MRAM cell 180 by 20 to 30%. Thus, the magnitude of the switching current of the embodiment MRAM cell 180 is reduced by at least 20 % compared to the same MRAM cell 280 which lacks the first magnetic assist layer, the antiferromagnetic coupling spacer layer, and the second magnetic assist layer.

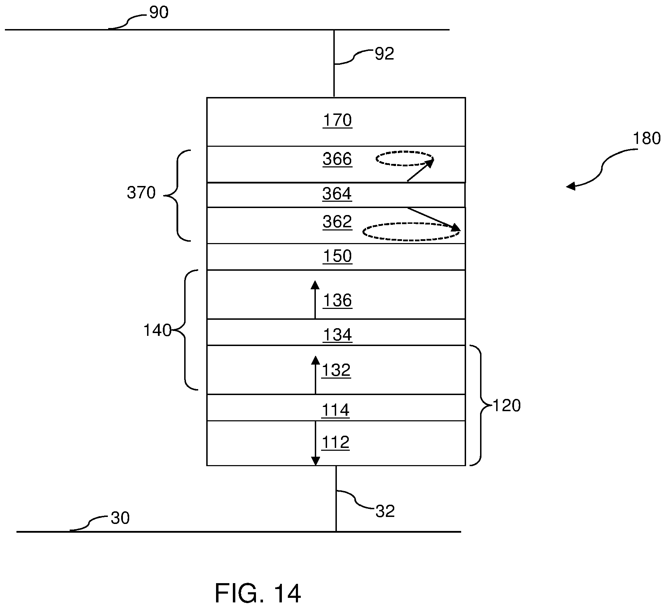

FIG. 14 illustrates a STT MRAM cell 180 according to a third example, which is not in accordance with the present invention. Layers 112, 114, 132, 134 and 136 of the STT MRAM cell 180 of the second example may be the same as respective layers 112, 114, 132, 134, and 136 of the STT MRAM cell 180 of the first embodiment illustrated in FIG. 2, and thus are described above with respect to the first embodiment. A first nonmagnetic spacer layer 150 is provided over the second side of the free layer 136 opposite to the first side of the free layer 136 which faces the nonmagnetic tunnel barrier layer 134. The first nonmagnetic spacer layer 150 includes a nonmagnetic material. The first nonmagnetic spacer layer 150 can include an electrically insulating (i.e., dielectric material) such as magnesium oxide. Alternatively, the first nonmagnetic spacer layer 150 can include an electrically conductive metallic material, such as tantalum, ruthenium, tantalum nitride, copper, or copper nitride. The thickness of the first nonmagnetic spacer layer 150 can be in a range from 0.2 nm to 2 nm, although lesser and greater thicknesses can also be employed.

A spin torque layer 362 can be provided on the first nonmagnetic spacer layer 150. In the example shown in FIG. 14, the spin torque layer 362 includes a first magnetic material having a first conical magnetization (e.g., magnetization direction) with respect to a vertical direction that is parallel to the fixed vertical magnetization (e.g., magnetization direction) of the reference layer 132. As used herein, a "conical magnetization" refers to a rotating magnetization (e.g., magnetization direction) having an angle greater than zero but less than 90 degrees, such as 10 to 80 degrees, for example 30 to 60 degrees with respect to an axis parallel to the fixed vertical magnetization (e.g., magnetization direction) of the reference layer 132.

A conical magnetization can be provided for various symmetry types for the magnetic anisotropy energy per volume. For example, a ferromagnetic film having magnetic anisotropy energy per volume having an axis of sixfold rotational symmetry about a vertical axis perpendicular to the plane of the ferromagnetic film can have a functional dependence on the tilt angle θ from the vertical axis and the azimuthal angle φ in the form of: E/V = K₁sin²θ + K₂sin⁴θ+K₃sin⁶θcos(6φ). If K₁ is negative and K₂ is greater than K₁/2, the ferromagnetic film has a bidirectional cone of easy magnetization direction at two values of q. The cone angles θ_{c1} and θ_{c2} for the bidirectional cone of easy magnetization direction are related by θ_{c2} = π - θ_{c1}.

Ferromagnetic films having different magnetic anisotropy symmetry can provide a conical magnetization is a similar manner. For example, a ferromagnetic film having magnetic anisotropy energy per volume having a tetrahedral symmetry can have a functional dependence on the tilt angle θ from the vertical axis and the azimuthal angle φ in the form of: E/V = K₁sin²θ + K₂sin⁴θ+K₃sin⁴θsin(2φ). A ferromagnetic film having magnetic anisotropy energy per volume having a rhombohedral symmetry can have a functional dependence on the tilt angle θ from the vertical axis and the azimuthal angle φ in the form of: E/V = K₁sin²θ + K₂sin⁴θ+K₃cosθsin³θcos(3φ). If the value of K₃ is zero or insignificant compared to 1/2 k_{B}T in which k_{B} is the Boltzmann constant and T is room temperature in Kelvin, i.e., 293.15 in the magnetic anisotropy energy per volume, the conical magnetization is free to rotate (e.g., oscillate with a high frequency) around the vertical axis.

The azimuthally-dependent component of the magnetic anisotropy of the spin torque layer 362 may be zero or insignificant compared to the thermal energy at room temperature, i.e., k_{B}T in which k_{B} is the Boltzmann constant and T is 297.15 Kelvin (which is the room temperature). For example, the maximum variation of the magnetic anisotropy energy per unit volume around a vertical axis that is parallel to the fixed vertical magnetization of the reference layer 132 can be less than 1/2 times the thermal energy at room temperature. In such cases, the conical magnetization of the spin torque layer 362 is free to precess within the horizontal plane that is parallel to the interface between the first nonmagnetic spacer layer 150 and the spin torque layer 362 upon application of electrical current through the spin torque layer 362. The magnetic energy of the spin torque layer 362 may be invariant under rotation of the magnetization of the spin torque layer 362 within the horizontal plane.

The spin torque layer 362 can include any ferromagnetic film that provides a conical magnetization. For example, the spin torque layer 362 can include a conical magnetization material such as rare-earth elements such as neodymium, erbium, or alloys of at least one rare-earth magnetic element and non-rare-earth element such as iron, boron, cobalt, copper, and/or zirconium. The spin torque layer 362 can include a homogeneous conical magnetization material, i.e., a homogeneous material that provides a conical magnetization. As used herein, a "homogeneous" material refers to a material having a uniform material composition throughout. The thickness of the spin torque layer 362 can be in a range from 0.6 nm to 10 nm, such as from 1.2 nm to 5 nm, although lesser and greater thicknesses can also be employed.

A second nonmagnetic spacer layer 364 can be located on the spin torque layer 362 on the opposite side of the first nonmagnetic spacer layer 150. The second nonmagnetic spacer layer 364 may comprise an electrically insulating layer, such as magnesium oxide, having a thickness between 0.2 nm and 2 nm.

A spin polarization layer 366 can be provided on the second nonmagnetic spacer layer 364. In another embodiment, the order of formation of the spin torque layer 362 and the spin polarization layer 366 can be reversed, such that the spin polarization layer 366 is located closer to the free layer 136 than the spin torque layer 362. In general, a spin torque oscillator stack (e.g., an assist layer stack) 370 includes the second nonmagnetic spacer layer 364 located between the spin torque layer 362 and the spin polarization layer 366.

The spin polarization layer 366 has a conical magnetization, which is herein referred to as a second conical magnetization. The spin polarization layer 366 can include a single magnetic material layer or a plurality of magnetic material layers. The second conical magnetization of the spin polarization layer 366 can be provided by the single magnetic material layer having the second conical magnetization, or can be provided by a set of ferromagnetic material layers having an in-plane magnetization and a perpendicular (i.e., vertical or axial) magnetization. The second magnetic material has an in-plane magnetization component that is perpendicular to the fixed vertical magnetization (e.g., magnetization direction) of the reference layer 132. The in-plane magnetization component of the second magnetic material is antiferromagnetically coupled to the in-plane component of the first conical magnetization.

FIG. 14 illustrates an example in which the spin polarization layer 366 consists of a single ferromagnetic material layer having the second conical magnetization with respect to a vertical direction that is parallel to the fixed vertical magnetization of the reference layer 132. The azimuthally-dependent component of the magnetic anisotropy of the spin polarization layer 366 may be zero or insignificant compared to the thermal energy at room temperature, i.e., k_{B}T in which k_{B} is the Boltzmann constant and T is 297.15 Kelvin (which is the room temperature). For example, the maximum variation of the magnetic anisotropy energy per unit volume around a vertical axis that is parallel to the fixed vertical magnetization of the reference layer 132 can be less than 1/2 times the thermal energy at room temperature. In such cases, the conical magnetization of the spin polarization layer 366 is free to precess within the horizontal plane that is parallel to the interface between the first nonmagnetic spacer layer 150 and the spin torque layer 362 upon application of electrical current through the spin polarization layer 366. The magnetic energy of the spin polarization layer 366 may be invariant under rotation of the magnetization of the spin polarization layer 366 within the horizontal plane.

The spin polarization layer 366 can include any ferromagnetic film that provides a conical magnetization. For example, the spin polarization layer 366 can include a conical magnetization material such as rare-earth elements such as neodymium, erbium, or alloys of at least one rare-earth magnetic element and non-rare-earth element such as iron, boron, cobalt, copper, and/or zirconium. The spin polarization layer 366 can include a homogeneous conical magnetization material, i.e., a homogeneous material that provides a conical magnetization. The ferromagnetic materials of the spin torque layer 362 and the spin polarization layer 366 may be the same or different. The thickness of the spin polarization layer 366 can be in a range from 0.6 nm to 10 nm, such as from 1.2 nm to 5 nm, although lesser and greater thicknesses can also be employed.

In case the magnetization of the spin polarization layer 366 is a conical magnetization, i.e., a second conical magnetization, the second conical magnetization of the spin polarization layer 366 can couple with the first conical magnetization of the spin torque layer 362 in various modes.

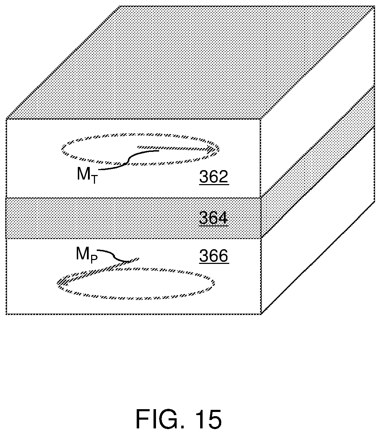

FIG. 15 illustrates a first mode of the antiferromagnetic coupling between the first conical magnetization M_{T} of the spin torque layer 362 and the second conical magnetization M_{P} of the spin polarization layer 366 within the exemplary spin-transfer torque MRAM cell 180. FIG. 15 illustrates the relative alignment between the first conical magnetization M_{T} of the spin torque layer 362 and the second conical magnetization M_{P} of the spin polarization layer 366 at an instant during precessing. In the first mode, the vertical component of the first conical magnetization M_{T} of the spin torque layer 362 and the vertical component of the second conical magnetization M_{P} of the spin polarization layer 366 can be antiparallel to each other.

In this mode, the in-plane component of the first conical magnetization of the spin torque layer 362 and the in-plane magnetization component of the magnetization (which can be the second conical magnetization) of the spin polarization layer 366 can be antiferromagnetically aligned. In this mode, the in-plane component of the first conical magnetization of the spin torque layer 362 and the in-plane magnetization component of the magnetization of the spin polarization layer 366 are free to precess around a vertical axis that is parallel to the vertical direction (i.e., a direction that is parallel to the fixed vertical magnetization (e.g., magnetization direction) of the reference layer 132 and that is perpendicular to the various interfaces of the layer stack (120, 140, 150, 370, 170)) while maintaining antiferromagnetic alignment upon application of electrical current through the spin torque layer 362, the second nonmagnetic spacer layer 364, and the spin polarization layer 366. The fixed vertical magnetization of the reference layer 132 maintains a same orientation upon application of electrical current through the reference layer 132.

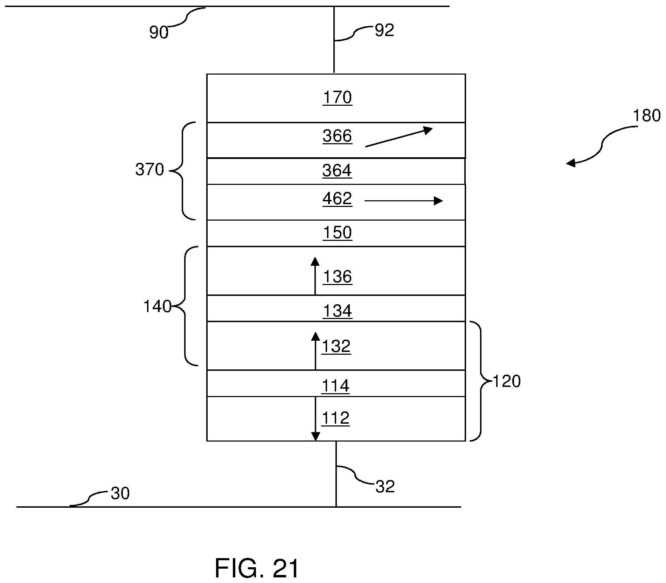

In FIG. 15, the magnetization M_{T} of the spin torque layer 362 can be in a horizontal plane (as will be described in more detail with respect to the example below which is illustrated in FIG. 21) or the magnetization M_{T} of the spin torque layer 362 can be conical and its cone angle (i.e., the angle between the vertical direction perpendicular to the interfaces between the various material layers and the vector representing the direction of the first conical magnetization M_{T}) and the cone angle of the second conical magnetization M_{P} of the spin polarization layer 366 can remain the same during precessing of the first conical magnetization M_{T} of the spin torque layer 362 and the second conical magnetization M_{P} of the spin polarization layer 366, which occurs during programming of the magnetization of the free layer 136 (i.e., during flipping of the vertical magnetization of the free layer 136 from a parallel state to an antiparallel state or vice versa). The relative angle between the total magnetization (i.e., the second conical magnetization) of the spin polarization layer 366 and the first conical magnetization of the spin torque layer 362 may remain fixed at a value selected within a range from, and not including, 90 degrees to, and including, 180 degrees upon application of electrical current through the spin torque layer 362, the second nonmagnetic spacer layer 364, and the spin polarization layer 366.

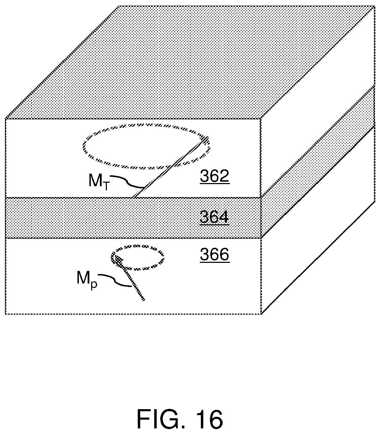

FIG. 16 illustrates a second mode of the antiferromagnetic coupling between the first conical magnetization M_{T} of the spin torque layer 362 and the second conical magnetization M_{P} of the spin polarization layer 366 within the exemplary spin-transfer torque MRAM cell 180. FIG. 16 illustrates the relative alignment between the first conical magnetization M_{T} of the spin torque layer 362 and the second conical magnetization M_{P} of the spin polarization layer 366 at an instant during precessing. In the second mode, the vertical component of the first conical magnetization M_{T} of the spin torque layer 362 and the vertical component of the second conical magnetization M_{P} of the spin polarization layer 366 can be parallel to each other, i.e., both can point upward or both can point downward.

The cone angle of the first conical magnetization M_{T} of the spin torque layer 362 (i.e., the angle between the vertical direction perpendicular to the interfaces between the various material layers and the vector representing the direction of the first conical magnetization M_{T}) and the cone angle of the second conical magnetization M_{P} of the spin polarization layer 366 can vary during precessing of the first conical magnetization M_{T} of the spin torque layer 362 and the second conical magnetization M_{P} of the spin polarization layer 366. In one embodiment, a relative angle between the total magnetization (e.g., the second conical magnetization) of the spin polarization layer 366 and the first conical magnetization of the spin torque layer 362 varies within a range from, and not including, 90 degrees to, and including, 180 degrees upon application of electrical current through the spin torque layer 362, the second nonmagnetic spacer layer 364, and the spin polarization layer 366.

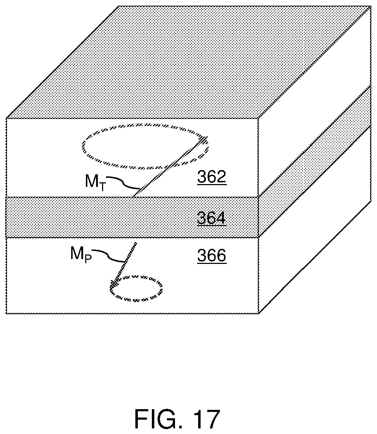

FIG. 17 illustrates a third mode of the antiferromagnetic coupling between the first conical magnetization M_{T} of the spin torque layer 362 and the second conical magnetization M_{P} of the spin polarization layer 366 within the exemplary spin-transfer torque MRAM cell 180. FIG. 17 illustrates the relative alignment between the first conical magnetization M_{T} of the spin torque layer 362 and the second conical magnetization M_{P} of the spin polarization layer 366 at an instant during precessing. In the third mode, the vertical component of the first conical magnetization M_{T} of the spin torque layer 362 and the vertical component of the second conical magnetization M_{P} of the spin polarization layer 366 can be antiparallel to each other, i.e., one points upward and the other points downward.

The cone angle of the first conical magnetization M_{T} of the spin torque layer 362 (i.e., the angle between the vertical direction perpendicular to the interfaces between the various material layers and the vector representing the direction of the first conical magnetization M_{T}) and the cone angle of the second conical magnetization M_{P} of the spin polarization layer 366 can vary during precessing of the first conical magnetization M_{T} of the spin torque layer 362 and the second conical magnetization M_{P} of the spin polarization layer 366. In one embodiment, a relative angle between the total magnetization (e.g., the second conical magnetization) of the spin polarization layer 366 and the first conical magnetization of the spin torque layer 362 varies within a range from, and not including, 90 degrees to, and including, 180 degrees upon application of electrical current through the spin torque layer 362, the second nonmagnetic spacer layer 364, and the spin polarization layer 366.

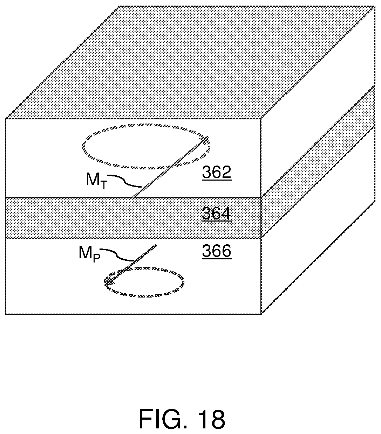

FIG. 18 illustrates a fourth mode of the antiferromagnetic coupling between the first conical magnetization M_{T} of the spin torque layer 362 and the second conical magnetization M_{P} of the spin polarization layer 366 within the exemplary spin-transfer torque MRAM cell 180. FIG. 18 illustrates the relative alignment between the first conical magnetization M_{T} of the spin torque layer 362 and the second conical magnetization M_{P} of the spin polarization layer 366 at an instant during precessing. In the fourth mode, the vertical component of the first conical magnetization M_{T} of the spin torque layer 362 and the vertical component of the second conical magnetization M_{P} of the spin polarization layer 366 may antiparallel to each other and the frequency of the first and second magnetization is the same such that the first and second magnetization direction vectors point in opposite directions (e.g., when one points left, the other points right and vice-versa). Thus, the first and second magnetization directions are anti-parallel in both vertical and horizontal directions (e.g., both the vertical and horizontal components of the first and second conical magnetization directions are antiparallel) in the fourth mode.

This fourth mode results in a high amount of noise and is not preferred compared to the first, second and third modes. Thus, the first and second magnetization directions are preferably not antiparallel in both vertical and horizontal directions.

Referring back to FIG. 14, the spin polarization layer 366 can be provided as a single spin polarization layer having a homogeneous composition and can have the second conical magnetization with respective to the vertical direction. Generally, the single spin polarization layer can have an axial magnetization component that is parallel or antiparallel to an axial magnetization component of the first conical magnetization of the spin torque layer 362. In some embodiments, the spin polarization layer 366 can have an axial magnetization component (i.e., a vertical magnetization component) that is antiparallel to an axial component of the conical magnetization of the spin torque layer 362. The spin polarization layer 366 can have an axial magnetization component (i.e., a vertical magnetization component) that is parallel to an axial component of the conical magnetization of the spin torque layer 362.

A nonmagnetic capping layer 170 can be located over the spin polarization layer 366. The nonmagnetic capping layer 170 can include a nonmagnetic, electrically conductive material such as W, Ti, Ta, WN, TiN, TaN, Ru, and Cu. The thickness of the nonmagnetic capping layer 170 can be in a range from 1 nm to 20 nm, although lesser and greater thicknesses can also be employed.

The layer stack including the material layers from the SAF structure 120 to the nonmagnetic capping layer 170 can be deposited upward or downward, i.e., from the SAF structure 120 toward the nonmagnetic capping layer 170 or from the nonmagnetic capping layer 170 toward the SAF structure 120. The layer stack can be formed as a stack of continuous layers, and can be subsequently patterned into discrete patterned layer stacks for each MRAM cell 180.

MRAM cell 180 can include a first terminal 92 that is electrically connected to or comprises a portion of a bit line 90 (shown in FIG. 1) and second terminal 32 that is electrically connected to or comprises a portion of a word line 30 (shown in FIG. 1). The location of the first and second terminals may be switched such that the first terminal is electrically connected to the SAF structure 120 and the second terminal is electrically connected to the capping layer 170.

Optionally, each MRAM cell 180 can include a dedicated steering device, such an access transistor or diode configured to activate a respective discrete patterned layer stack (120, 140, 150, 162, 164, 166, 170) upon application of a suitable voltage to the steering device. The steering device may be electrically connected between the patterned layer stack and one of the respective word lines 30 or bit lines 90 of the respective MRAM cell 180.

The polarity of the voltage applied to the first terminal 92 can be changed depending on the polarity of the magnetization state to be programmed in the free layer 136. For example, a voltage of a first polarity can be applied to the first terminal 92 (with respect to the second terminal 32) during a transition from an antiparallel state to a parallel state, and a voltage of a second polarity (which is the opposite of the first polarity) can be applied to the first terminal 92 during a transition from a parallel state to an antiparallel state. Further, variations in the circuitry for activating the discrete patterned layer stack (120, 140, 150, 162, 164, 166, 170) are also contemplated herein.

The magnetization direction of the free layer 136 can be flipped (i.e., from upward to downward or vice versa) by flowing electrical current through the discrete patterned layer stack (120, 140, 150, 362, 364, 366, 170). The magnetization direction of the free layer 136 can precess around the vertical direction (i.e., the direction of the flow of the electrical current) during the programming process until the direction of the magnetization flips by 180 degrees, at which point the flow of the electrical current stops.

The first conical magnetization of the spin torque layer 362 and the second conical magnetization of the spin polarization layer 366 are free to precess around a vertical axis that is parallel to the fixed vertical magnetization of the reference layer 132 upon application of electrical current through the spin torque layer 362, the second nonmagnetic spacer layer 364, and the spin polarization layer 366, e.g., during programming. The fixed vertical magnetization of the reference layer 132 maintains a same orientation upon application of electrical current through the reference layer 132.

During operation of the MRAM cell, electrical current can be flowed through the magnetic tunnel junction 140, the first nonmagnetic spacer layer 150, the spin torque layer 362, the second nonmagnetic spacer layer 364, and the spin polarization layer 366. The spin torque oscillator stack 370 comprising the combination of the spin torque layer 362, the second nonmagnetic spacer layer 364, and the spin polarization layer 366 is configured to provide an initial non-vertical torque to a magnetization of the free layer 136 during an initial phase of precession of the magnetization of the free layer 136 around a vertical axis that is parallel to the fixed vertical magnetization of the reference layer 132 upon initiation of flow of electrical current through the MRAM cell 180. The MRAM cell 180 is configured to provide magnetic coupling between the magnetization of the free layer 136 and the first magnetization of the spin torque layer 362 during precession of the magnetization of the free layer 136 around a vertical axis that is parallel to the fixed vertical magnetization of the reference layer 132, and to provide synchronized precession of the first magnetization of the spin torque layer 362 and the magnetization of the free layer 136 while electrical current flows through the MRAM cell 180.

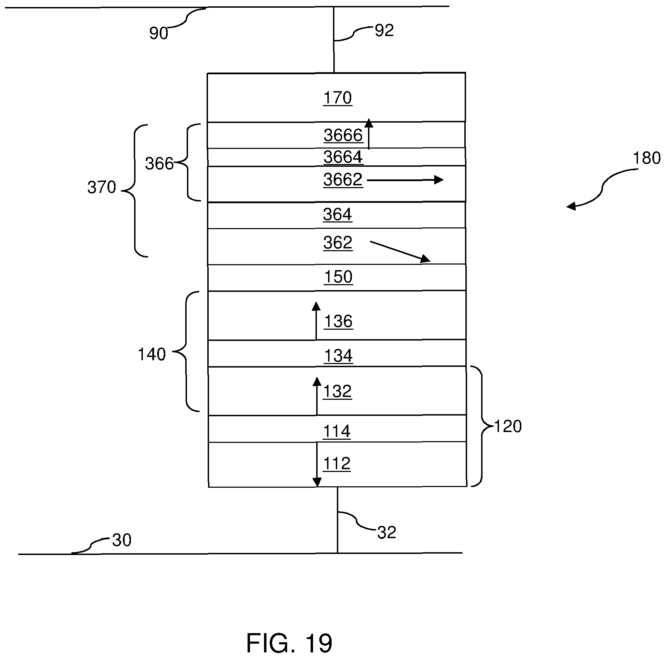

Referring to FIG. 19, a second configuration of the exemplary spin-transfer torque MRAM cell 180 is illustrated. The spin polarization layer 366 includes a layer stack of multiple layers (3662, 3664, 3666) having different material compositions. The spin polarization layer 366 includes a layer stack of a first spin polarization component layer 3662 having a magnetization that is the same as the in-plane magnetization component of the second conical magnetization. The first spin polarization component layer 3662 can have a zero magnetic anisotropy or negative uniaxial magnetic anisotropy so that the magnetization of the first spin polarization component layer 3662 is parallel to the interfaces among the various layers of the MRAM cell 180.

The first spin polarization component layer 3662 may comprise, and/or consists essentially of, a cobalt-iridium alloy. The material composition of the cobalt-iridium alloy can be selected to provide negative uniaxial magnetic anisotropy. The cobalt-iridium alloy can include cobalt atoms at an atomic concentration in a range from 60 % to 98 %, such as from 70 % to 90 %, and iridium atoms at the atomic concentration of the balance. In an illustrative example, a cobalt-iridium alloy having a composition of Co_{0.8}Ir_{0.2} has a K₁ value of about -0.6 × 10⁶ J/m³. The first spin polarization component layer 3662 may comprise, and/or consist essentially of, a cobalt-iron alloy. The material composition of the cobalt-iron alloy can be selected to provide negative uniaxial magnetic anisotropy. The cobalt-iron alloy can include cobalt atoms at an atomic concentration in a range from 80 % to 99.8 %, such as from 90 % to 99.5 %, and iron atoms at the atomic concentration of the balance. In an illustrative example, a cobalt-iron alloy having a composition of Co_{0.9}Ir_{0.1} has a K₁ value of about -0.99 × 10⁶ J/m³. The first spin polarization component layer 3662 may comprise, and/or consist essentially of, a cobalt-iron-boron (CoFeB) alloy. The thickness of the first spin polarization component layer 3662 can be in a range from 1 nm to 10 nm, such as from 1.5 nm to 6 nm, although lesser and greater thicknesses can also be employed.

The first spin polarization component layer 3662 includes a multilayer stack containing multiple repetitions of a first magnetic material layer and a second magnetic material layer. The first magnetic material layer can include, and/or can consist essentially of, a first magnetic material. The second magnetic material layer can include, and/or can consist essentially of, a second magnetic material.

The first magnetic material layers may comprise cobalt, and the second magnetic material layers may comprise iron. The first magnetic material layers may consist essentially of cobalt, and the second magnetic material layers may consist essentially of iron. The thickness of each first magnetic material layer can be in a range from 0.3 nm to 1 nm, and the thickness of each second magnetic material layer can be in a range from 0.3 nm to 1 nm. The total number of repetitions (i.e., the total number of pairs of a first magnetic material layer and a second magnetic material layer) within the first spin polarization component layer 3662 can be in a range from 2 to 20, such as from 4 to 10. The multilayer stack may comprise a periodic repetition of a unit layer stack that includes a first magnetic material layer and a second magnetic material layer. In an illustrative example, an interlaced cobalt-iron multilayer stack including repetitions of a unit layer stack consisting of a cobalt layer and an iron layer having the same thickness can have a K₁ value of about -1.1 × 10⁶ J/m³.

The spin polarization layer 366 further includes a second spin polarization component layer 3666 having an axial magnetization that is parallel or antiparallel to the vertical direction of the reference layer 132. The second spin polarization component layer 3666 may include a multilayer stack of cobalt layers and either platinum or palladium layers. The second spin polarization component layer 3666 can have a positive uniaxial magnetic anisotropy so that the magnetization of the second spin polarization component layer 3666 is axial, i.e., perpendicular to the interfaces among the various layers of the MRAM cell 180. The axial magnetization of the second spin polarization component layer 3666 can be parallel or antiparallel to the fixed vertical direction of magnetization of the reference layer 132.

The second spin polarization component layer 3666 can be vertically spaced from the first spin polarization component layer 3662 by an optional third nonmagnetic spacer layer 3664. The third nonmagnetic spacer layer 3664 can include a nonmagnetic material such as MgO, Cu, Ag, AgSn, Cr, or Ge. The first spin polarization component layer 3662 can be in contact with the second nonmagnetic spacer layer 364.

In this case, the combined magnetization of the first spin polarization component layer 3662 and the second spin polarization component layer 3666 provides the second conical magnetization, which is free to rotate (e.g., oscillate) around the vertical axis during programming of the MRAM cell 180. In this case, the combined magnetization of the first spin polarization component layer 3662 and the second spin polarization component layer 3666 provides an additional conical magnetization (i.e., the second conical magnetization) that is coupled to the first conical magnetization of the spin torque layer 362. During programming, the second conical magnetization and the first conical magnetization precess around a vertical axis that is parallel to the vertical direction of the magnetization of the reference layer 132 upon application of electrical current through the spin torque layer 362, the second nonmagnetic spacer layer 364, and the spin polarization layer 366. The mode of coupling between the first conical magnetization and the second conical magnetization is preferably any of the first, second or third modes illustrated in FIGS. 15 - 17.

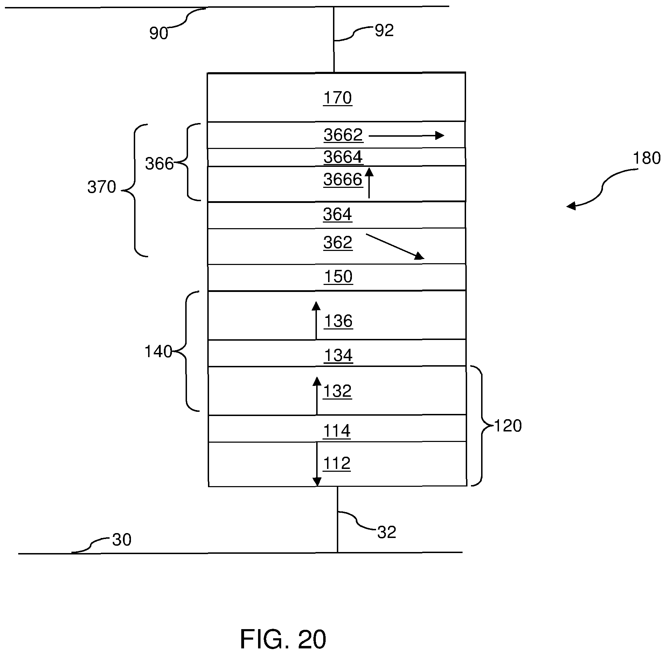

Referring to FIG. 20, a third configuration of the exemplary spin-transfer torque MRAM cell 180 can be derived from the second configuration of the exemplary spin-transfer torque MRAM cell 180 by exchanging the positions of the first spin polarization component layer 3662 and the second spin polarization component layer 3666. In this case, the second spin polarization component layer 3666 can be in contact with the second nonmagnetic spacer layer 364. The exemplary spin-transfer torque MRAM cell 180 in the third configuration can operate in the same manner as the exemplary spin-transfer torque MRAM cells 180 in the first and second configurations.

FIG. 21 illustrates a fourth configuration of an exemplary spin-transfer torque MRAM cell 180. The fourth configuration of the exemplary spin-transfer torque MRAM cell 180 can be derived from the first, second, and third configuration of the exemplary spin-transfer torque MRAM cell 180 by substituting a spin torque layer 462 having an in-plane magnetization (i.e., having negative uniaxial magnetic anisotropy) in place of the spin torque layer 362 having a first conical magnetization. In other words, the axial component of the magnetization of the spin torque layer 462 can be zero, and the magnetization (e.g., magnetization direction) of the spin torque layer 462 can consist of an in-plane component. In this case, the total magnetization of the spin torque layer 462 is the same as the in-plane magnetization component of the spin torque layer 462.

The spin torque layer 462 may comprise a homogeneous negative uniaxial magnetic anisotropy material. As used herein, a "homogeneous" material refers to a material having a uniform material composition throughout. The spin torque layer 462 may comprise, and/or consist essentially of, a cobalt-iridium alloy. The material composition of the cobalt-iridium alloy can be selected to provide negative uniaxial magnetic anisotropy. The cobalt-iridium alloy can include cobalt atoms at an atomic concentration in a range from 60 % to 98 %, such as from 70 % to 90 %, and iridium atoms at the atomic concentration of the balance. In an illustrative example, a cobalt-iridium alloy having a composition of Co_{0.8}Ir_{0.2} has a K₁ value of about -0.6 × 106 J/m³. The spin torque layer 462 may comprise, and/or consist essentially of, a cobalt-iron alloy. The material composition of the cobalt-iron alloy can be selected to provide negative uniaxial magnetic anisotropy. The cobalt-iron alloy can include cobalt atoms at an atomic concentration in a range from 80 % to 99.8 %, such as from 90 % to 99.5 %, and iron atoms at the atomic concentration of the balance. In an illustrative example, a cobalt-iron alloy having a composition of Co_{0.9}Ir_{0.1} has a K₁ value of about -0.99 × 10⁶ J/m³. The spin torque layer 462 may comprise, and/or consist essentially of, a cobalt-iron-boron (CoFeB) alloy. The thickness of the spin torque layer 462 can be in a range from 1 nm to 10 nm, such as from 1.5 nm to 6 nm, although lesser and greater thicknesses can also be employed.

The spin torque layer 462 may include a multilayer stack containing multiple repetitions of a first magnetic material layer and a second magnetic material layer. The first magnetic material layer can include, and/or can consist essentially of, a first magnetic material. The second magnetic material layer can include, and/or can consist essentially of, a second magnetic material.

The first magnetic material layers may comprise cobalt, and the second magnetic material layers may comprise iron. The first magnetic material layers may consist essentially of cobalt, and the second magnetic material layers may consist essentially of iron. The thickness of each first magnetic material layer can be in a range from 0.3 nm to 1 nm, and the thickness of each second magnetic material layer can be in a range from 0.3 nm to 1 nm. The total number of repetitions (i.e., the total number of pairs of a first magnetic material layer and a second magnetic material layer) within the spin torque layer 462 can be in a range from 2 to 20, such as from 4 to 10. The multilayer stack may comprise a periodic repetition of a unit layer stack that includes a first magnetic material layer and a second magnetic material layer. In an illustrative example, an interlaced cobalt-iron multilayer stack including repetitions of a unit layer stack consisting of a cobalt layer and an iron layer having the same thickness can have a K1 value of about -1.1 × 10⁶ J/m³. The spin torque layer 462 may be used with any of the spin polarization layers 366 described above with respect to the first embodiment or the second or third examples.

The various example combinations of a spin torque layer (362 or 462) and a spin polarization layer 366 provide the benefit of reduction in the current density for making the parallel to antiparallel transition and in the current density for making the antiparallel to parallel transition by providing initial non-vertical torque to the magnetization of the free layer 136 during an initial phase of precession of the magnetization of the free layer 136 around a vertical axis that is parallel to the fixed vertical magnetization of the reference layer 132 upon initiation of flow of electrical current through the MRAM cell 180.

Specifically, during the writing process with current flowing across the stack of the MRAM cell 180, magnetization of both the spin torque layer and the spin polarization layer are oscillating at high frequency with a cone angle (the angle between the magnetization and the normal axis of the stack layer interfaces) between 0 and 90 degrees, as shown in FIGS. 14 to 18. The oscillating magnetization of spin torque layer can have one or more of the following non-limited benefits leading to lower switching current for the free layer 136. First, an in-plane component of the spin torque layer 362 magnetization that is orthogonal to the initial magnetization of the free layer 136 may produce a large spin torque on the free layer 136 to help its initial precession. Second, the oscillating magnetization of the spin torque layer 362 may lead to rotation of the aforementioned torque, which helps to maximize the assist effect throughout the precessional switching process of the free layer 136. Third, a direct field produced by the spin torque layer 362 magnetization in the free layer 136 may be largely an in-plane AC field, which is also orthogonal to the free layer's initial magnetization direction. Thus, this also helps provide the rotating torque to assist free layer 136 switching.

Although the foregoing refers to particular preferred embodiments, it will be understood that the disclosure is not so limited. It will occur to those of ordinary skill in the art that various modifications may be made to the disclosed embodiments and that such modifications are intended to be within the scope of the disclosure. Where an embodiment employing a particular structure and/or configuration is illustrated in the present disclosure, it is understood that the present disclosure may be practiced with any other compatible structures and/or configurations that are functionally equivalent provided that such substitutions are not explicitly forbidden or otherwise known to be impossible to one of ordinary skill in the art. The scope of protection is only limited by the appended claims.

## Claims

1. A magnetoresistive random access memory, MRAM, device (500; 180) comprising:
a magnetic tunnel junction (140) comprising a reference layer (132) having a fixed magnetization direction, a free layer (136), and a nonmagnetic tunnel barrier layer (134) located between the reference layer (132) and the free layer (136);
a negative-magnetic-anisotropy assist layer (160; 260) having negative magnetic anisotropy that provides an in-plane magnetization within a plane that is perpendicular to the fixed magnetization direction; and
a first nonmagnetic spacer layer (150) located between the free layer (132) and the negative-magnetic-anisotropy assist layer (160; 260); the MRAM device **characterized by**:
a pinned magnetization layer (192) having positive uniaxial magnetic anisotropy which provides a magnetization direction that is parallel or antiparallel to the fixed magnetization direction of the reference layer; and
a second nonmagnetic spacer layer (190) located between the negative-magnetic-anisotropy assist layer (160; 260) and the pinned magnetization layer (192).

2. The MRAM device of Claim 1, wherein:
the negative-magnetic-anisotropy assist layer (160; 260) has an easy magnetization plane that is perpendicular to the fixed magnetization of the reference layer (132); and
the negative-magnetic-anisotropy assist layer (160; 260) has no easy axis direction within the easy magnetization plane.

3. The MRAM device of Claim 1, wherein:
the free layer (136) has positive magnetic anisotropy to provide bistable magnetization states that include a parallel state having a magnetization that is parallel to the fixed vertical magnetization and an antiparallel state having a magnetization that is antiparallel to the fixed vertical magnetization; and
magnetic energy of the negative-magnetic-anisotropy assist layer (160; 260) is invariant under rotation of the magnetization of the negative-magnetic-anisotropy assist layer (160; 260) within the horizontal plane.

4. The MRAM device of Claim 1, wherein the negative-magnetic-anisotropy assist layer (160) comprises a homogeneous negative magnetic anisotropy material.

5. The MRAM device of Claim 4, wherein the negative-magnetic-anisotropy assist layer (160) comprises a cobalt-iridium alloy or a cobalt-iron alloy; optionally wherein:
the negative-magnetic-anisotropy assist layer (160) comprises the cobalt-iridium alloy comprising 70 to 90 atomic percent cobalt and 10 to 30 atomic percent iridium; or
the negative-magnetic-anisotropy assist layer (160) comprises the cobalt-iron alloy comprising 90 to 99.5 atomic percent cobalt and 0.5 to 10 atomic percent iron.

6. The MRAM device of Claim 1, wherein the negative-magnetic-anisotropy assist layer (260) comprises a multilayer stack including multiple repetitions of a first magnetic material (262) layer and a second magnetic material layer (264); optionally wherein:
the first magnetic material layer (262) comprises cobalt; and
the second magnetic material layer (264) comprises iron.

7. The MRAM device of Claim 1, further comprising a synthetic antiferromagnetic structure (120) comprising the reference layer (132), a fixed ferromagnetic layer (112) having a magnetization that is antiparallel to the fixed magnetization direction of the reference layer (132), and an antiferromagnetic coupling layer (114) located between the reference layer (132) and the fixed ferromagnetic layer (112).

8. The MRAM device of Claim 1, wherein a combination of the magnetization of the pinned magnetization layer (192) and the magnetization of the negative-magnetic-anisotropy assist layer (160; 260) applies a magnetic field which is not parallel and not perpendicular to the fixed magnetization direction of the reference layer (132) on the magnetization of the free layer (136).

9. The MRAM device of Claim 1, further comprising a nonmagnetic capping layer (170) located over the negative-magnetic-anisotropy assist layer (160; 260).

10. A method of operating a magnetoresistive random access memory, MRAM, device, comprising:
providing the MRAM device of Claim 1; and
flowing current through the magnetic tunnel junction (140), the first nonmagnetic spacer layer (150), and the negative-magnetic-anisotropy assist layer (160; 260).

11. The method of Claim 10, wherein the negative-magnetic-anisotropy assist layer (160; 260) provides an initial torque to a magnetization of the free layer (136) during an initial phase of precession of the magnetization of the free layer (136) around a vertical axis that is parallel to the fixed magnetization direction of the reference layer (132) upon initiation of the flowing of the current through the MRAM device (500); optionally wherein:
coupling occurs between an in-plane magnetization of the negative-magnetic-anisotropy assist layer (160; 260) and the magnetization of the free layer (136) during precession of the magnetization of the free layer (136) around a vertical axis that is parallel to the fixed magnetization direction of the reference layer (132), and
synchronized precession of the in-plane magnetization of the negative-magnetic-anisotropy assist layer (160; 260) and the magnetization of the free layer (136) occurs while the flowing of the current continues through the MRAM device (500).

12. The method of Claim 10, wherein:
the negative-magnetic-anisotropy assist layer (160; 260) has an easy magnetization plane that is perpendicular to the fixed magnetization of the reference layer (132); and
the negative-magnetic-anisotropy assist layer (160; 260) has no easy axis direction within the easy magnetization plane.

13. The method of Claim 10, wherein the negative-magnetic-anisotropy assist layer (260) comprises a multilayer stack including multiple repetitions of a first magnetic material layer (262) and a second magnetic material layer (264); optionally wherein:
the first magnetic material layer (262) consists essentially of cobalt; and
the second magnetic material layer (264) consists essentially of iron.

## Patentansprüche

1. Magnetoresistive Direktzugriffsspeicher-, MRAM-, Vorrichtung (500; 180), umfassend:
einen magnetischen Tunnelübergang (140), umfassend eine Referenzschicht (132), die eine feste Magnetisierungsrichtung aufweist, eine freie Schicht (136) und eine nichtmagnetische Tunnelbarriereschicht (134), die zwischen der Referenzschicht (132) und der freien Schicht (136) gelegen ist;
eine Hilfsschicht (160; 260) mit negativer magnetischer Anisotropie, die eine negative magnetische Anisotropie aufweist, die eine in der Ebene liegende Magnetisierung innerhalb einer Ebene bereitstellt, die senkrecht zur festen Magnetisierungsrichtung ist; und
eine erste nichtmagnetische Abstandsschicht (150), die zwischen der freien Schicht (132) und der Hilfsschicht (160; 260) mit negativer magnetischer Anisotropie gelegen ist; wobei die MRAM-Vorrichtung **gekennzeichnet ist durch**:
eine fixierte Magnetisierungsschicht (192), die positive uniaxiale magnetische Anisotropie aufweist, die eine Magnetisierungsrichtung bereitstellt, die parallel oder antiparallel zur festen Magnetisierungsrichtung der Referenzschicht ist; und
eine zweite nichtmagnetische Abstandsschicht (190), die zwischen der Hilfsschicht (160; 260) mit negativer magnetischer Anisotropie und der fixierten Magnetisierungsschicht (192) gelegen ist.

2. MRAM-Vorrichtung nach Anspruch 1, wobei:
die Hilfsschicht (160; 260) mit negativer magnetischer Anisotropie eine Ebene leichter Magnetisierung aufweist, die senkrecht zur festen Magnetisierung der Referenzschicht (132) ist; und
die Hilfsschicht (160; 260) mit negativer magnetischer Anisotropie innerhalb der Ebene leichter Magnetisierung keine leichte Achsenrichtung aufweist.

3. MRAM-Vorrichtung nach Anspruch 1, wobei:
die freie Schicht (136) eine positive magnetische Anisotropie aufweist, um bistabile Magnetisierungszustände bereitzustellen, die einen parallelen Zustand mit einer Magnetisierung, die parallel zur festen vertikalen Magnetisierung ist, und einen antiparallelen Zustand mit einer Magnetisierung einschließen, die antiparallel zur festen vertikalen Magnetisierung ist; und
die magnetische Energie der Hilfsschicht (160; 260) mit negativer magnetischer Anisotropie bei Drehung der Magnetisierung der Hilfsschicht (160; 260) mit negativer magnetischer Anisotropie innerhalb der horizontalen Ebene invariant ist.

4. MRAM-Vorrichtung nach Anspruch 1, wobei die Hilfsschicht (160) mit negativer magnetischer Anisotropie ein homogenes Material mit negativer magnetischer Anisotropie umfasst.

5. MRAM-Vorrichtung nach Anspruch 4, wobei die Hilfsschicht (160) mit negativer magnetischer Anisotropie eine Kobalt-Iridium-Legierung oder eine Kobalt-EisenLegierung umfasst; wobei optional:
die Hilfsschicht (160) mit negativer magnetischer Anisotropie die Kobalt-Iridium-Legierung umfasst, die 70 bis 90 Atomprozent Kobalt und 10 bis 30 Atomprozent iridium umfasst; oder
die Hilfsschicht (160) mit negativer magnetischer Anisotropie die Kobalt-EisenLegierung umfasst, die 90 bis 99,5 Atomprozent Kobalt und 0,5 bis 10 Atomprozent Eisen umfasst.

6. MRAM-Vorrichtung nach Anspruch 1, wobei die Hilfsschicht (260) mit negativer magnetischer Anisotropie einen mehrschichtigen Stapel umfasst, der mehrere Wiederholungen einer ersten magnetischen Materialschicht (262) und einer zweiten magnetischen Materialschicht (264) einschließt; wobei optional:
die erste magnetische Materialschicht (262) Kobalt umfasst; und
die zweite magnetische Materialschicht (264) Eisen umfasst.

7. MRAM-Vorrichtung nach Anspruch 1, weiter umfassend eine synthetische antiferromagnetische Struktur (120), die die Referenzschicht (132), eine feste ferromagnetische Schicht (112) mit einer Magnetisierung, die antiparallel zur festen Magnetisierungsrichtung der Referenzschicht (132) ist, und eine antiferromagnetische Kopplungsschicht (114), die zwischen der Referenzschicht (132) und der festen ferromagnetischen Schicht (112) gelegen ist, umfasst.

8. MRAM-Vorrichtung nach Anspruch 1, wobei eine Kombination aus der Magnetisierung der fixierten Magnetisierungsschicht (192) und der Magnetisierung der Hilfsschicht (160; 260) mit negativer magnetischer Anisotropie ein Magnetfeld auf die Magnetisierung der freien Schicht (136) anwendet, das weder parallel noch senkrecht zur festen Magnetisierungsrichtung der Referenzschicht (132) verläuft.

9. MRAM-Vorrichtung nach Anspruch 1, weiter umfassend eine nichtmagnetische Deckschicht (170), die über der Hilfsschicht (160; 260) mit negativer magnetischer Anisotropie gelegen ist.

10. Verfahren zum Betreiben einer magnetoresistiven Direktzugriffsspeicher-, MRAM-, Vorrichtung umfassend:
Bereitstellen der MRAM-Vorrichtung nach Anspruch 1; und
Fließen von Strom durch den magnetischen Tunnelübergang (140), die erste nichtmagnetische Abstandsschicht (150) und die Hilfsschicht (160; 260) mit negativer magnetischer Anisotropie.

11. Verfahren nach Anspruch 10, wobei die Hilfsschicht (160; 260) mit negativer magnetischer Anisotropie während einer Anfangsphase der Präzession der Magnetisierung der freien Schicht (136) um eine vertikale Achse, die parallel zur festen Magnetisierungsrichtung der Referenzschicht (132) ist, bei Beginn des Fließens des Stroms durch die MRAM-Vorrichtung (500) ein Anfangsdrehmoment für eine Magnetisierung der freien Schicht (136) bereitstellt; wobei optional:
Kopplung zwischen einer in der Ebene liegenden Magnetisierung der Hilfsschicht (160; 260) mit negativer magnetischer Anisotropie und der Magnetisierung der freien Schicht (136) während der Präzession der Magnetisierung der freien Schicht (136) um eine vertikale Achse auftritt, die parallel zur festen Magnetisierungsrichtung der Referenzschicht (132) ist, und
synchronisierte Präzession der in der Ebene liegenden Magnetisierung der Hilfsschicht (160; 260) mit negativer magnetischer Anisotropie und der Magnetisierung der freien Schicht (136) auftritt, während das Fließen des Stroms durch die MRAM-Vorrichtung (500) fortgesetzt wird.

12. Verfahren nach Anspruch 10, wobei:
die Hilfsschicht (160; 260) mit negativer magnetischer Anisotropie eine Ebene leichter Magnetisierung aufweist, die senkrecht zur festen Magnetisierung der Referenzschicht (132) ist; und
die Hilfsschicht (160; 260) mit negativer magnetischer Anisotropie innerhalb der Ebene leichter Magnetisierung keine leichte Achsenrichtung aufweist.

13. Verfahren nach Anspruch 10, wobei die Hilfsschicht (260) mit negativer magnetischer Anisotropie einen mehrschichtigen Stapel umfasst, der mehrere Wiederholungen einer ersten magnetischen Materialschicht (262) und einer zweiten magnetischen Materialschicht (264) einschließt; wobei optional:
die erste magnetische Materialschicht (262) im Wesentlichen aus Kobalt besteht; und
die zweite magnetische Materialschicht (264) im Wesentlichen aus Eisen besteht.

## Revendications

1. Dispositif à mémoire vive magnétorésistive, MRAM, (500; 180) comprenant :
une jonction tunnel magnétique (140) comprenant une couche de référence (132) présentant une direction de magnétisation fixe, une couche libre (136) et une couche barrière de tunnel non magnétique (134) située entre la couche de référence (132) et la couche libre (136) ;
une couche d'assistance à anisotropie magnétique négative (160 ; 260) présentant une anisotropie magnétique négative qui fournit une magnétisation dans le plan dans un plan qui est perpendiculaire à la direction de magnétisation fixe ; et
une première couche d'espacement non magnétique (150) située entre la couche libre (132) et la couche d'assistance à anisotropie magnétique négative (160 ; 260) ; le dispositif MRAM étant **caractérisé par** :
une couche de magnétisation bloquée (192) présentant une anisotropie magnétique uniaxiale positive qui fournit une direction de magnétisation qui est parallèle ou antiparallèle à la direction de magnétisation fixe de la couche de référence ; et
une seconde couche d'espacement non magnétique (190) située entre la couche d'assistance à anisotropie magnétique négative (160 ; 260) et la couche de magnétisation bloquée (192).

2. Dispositif MRAM selon la revendication 1, dans lequel :
la couche d'assistance à anisotropie magnétique négative (160 ; 260) présente un plan de magnétisation facile qui est perpendiculaire à la magnétisation fixe de la couche de référence (132) ; et
la couche d'assistance à anisotropie magnétique négative (160 ; 260) ne présente pas de direction d'axe facile dans le plan de magnétisation facile.

3. Dispositif MRAM selon la revendication 1, dans lequel :
la couche libre (136) présente une anisotropie magnétique positive pour fournir des états de magnétisation bistables qui incluent un état parallèle présentant une magnétisation qui est parallèle à la magnétisation verticale fixe et un état antiparallèle présentant une magnétisation qui est antiparallèle à la magnétisation verticale fixe ; et
l'énergie magnétique de la couche d'assistance à anisotropie magnétique négative (160; 260) ne varie pas sous une rotation de la magnétisation de la couche d'assistance à anisotropie magnétique négative (160; 260) dans le plan horizontal.

4. Dispositif MRAM selon la revendication 1, dans lequel la couche d'assistance à anisotropie magnétique négative (160) comprend un matériau homogène à anisotropie magnétique négative.

5. Dispositif MRAM selon la revendication 4, dans lequel la couche d'assistance à anisotropie magnétique négative (160) comprend un alliage cobalt-iridium ou un alliage cobalt-fer ; facultativement dans lequel :
la couche d'assistance à anisotropie magnétique négative (160) comprend l'alliage cobalt-iridium comprenant 70 à 90 pour cent atomiques de cobalt et 10 à 30 pour cent atomiques d'iridium ; ou
la couche d'assistance à anisotropie magnétique négative (160) comprend l'alliage cobalt-fer comprenant 90 à 99,5 pour cent atomiques de cobalt et 0,5 à 10 pour cent atomiques de fer.

6. Dispositif MRAM selon la revendication 1, dans lequel la couche d'assistance à anisotropie magnétique négative (260) comprend un empilement multicouche incluant de multiples répétitions d'une première couche de matériau magnétique (262) et d'une seconde couche de matériau magnétique (264) ; facultativement dans lequel :
la première couche de matériau magnétique (262) comprend du cobalt ; et
la seconde couche de matériau magnétique (264) comprend du fer.

7. Dispositif MRAM selon la revendication 1, comprenant en outre une structure antiferromagnétique synthétique (120) comprenant la couche de référence (132), une couche ferromagnétique fixe (112) présentant une magnétisation qui est antiparallèle à la direction de magnétisation fixe de la couche de référence (132), et une couche de couplage antiferromagnétique (114) située entre la couche de référence (132) et la couche ferromagnétique fixe (112).

8. Dispositif MRAM selon la revendication 1, dans lequel une combinaison de la magnétisation de la couche de magnétisation bloquée (192) et de la magnétisation de la couche d'assistance à anisotropie magnétique négative (160 ; 260) applique un champ magnétique qui n'est ni parallèle ni perpendiculaire à la direction de magnétisation fixe de la couche de référence (132) sur la magnétisation de la couche libre (136).

9. Dispositif MRAM selon la revendication 1, comprenant en outre une couche de recouvrement non magnétique (170) située au-dessus de la couche d'assistance à anisotropie magnétique négative (160 ; 260).

10. Procédé de fonctionnement d'un dispositif à mémoire vive magnétorésistive, MRAM, comprenant les étapes consistant à :
fournir le dispositif MRAM selon la revendication 1; et
faire circuler un courant à travers la jonction tunnel magnétique (140), la première couche d'espacement non magnétique (150) et la couche d'assistance à anisotropie magnétique négative (160 ; 260).

11. Procédé selon la revendication 10, dans lequel la couche d'assistance à anisotropie magnétique négative (160 ; 260) fournit un couple initial à une magnétisation de la couche libre (136) pendant une phase initiale de précession de la magnétisation de la couche libre (136) autour d'un axe vertical qui est parallèle à la direction de magnétisation fixe de la couche de référence (132) lors du lancement de la circulation du courant à travers le dispositif MRAM (500) ; facultativement dans lequel :
un couplage se produit entre une magnétisation dans le plan de la couche d'assistance à anisotropie magnétique négative (160 ; 260) et la magnétisation de la couche libre (136) pendant la précession de la magnétisation de la couche libre (136) autour d'un axe vertical qui est parallèle à la direction de magnétisation fixe de la couche de référence (132), et
une précession synchronisée de la magnétisation dans le plan de la couche d'assistance à anisotropie magnétique négative (160 ; 260) et de la magnétisation de la couche libre (136) se produit tandis que la circulation du courant continue à travers le dispositif MRAM (500).

12. Procédé selon la revendication 10, dans lequel :
la couche d'assistance à anisotropie magnétique négative (160; 260) présente un plan de magnétisation facile qui est perpendiculaire à la magnétisation fixe de la couche de référence (132) ; et
la couche d'assistance à anisotropie magnétique négative (160; 260) ne présente pas de direction d'axe facile dans le plan de magnétisation facile.

13. Procédé selon la revendication 10, dans lequel la couche d'assistance à anisotropie magnétique négative (260) comprend un empilement multicouche incluant de multiples répétitions d'une première couche de matériau magnétique (262) et d'une seconde couche de matériau magnétique (264) ; facultativement dans lequel :
la première couche de matériau magnétique (262) consiste essentiellement en du cobalt ; et
la seconde couche de matériau magnétique (264) consiste essentiellement en du fer.
